# EUROPÄISCHE PATENTSCHRIFT

(11) **EP 4 675 927 B1**
(45) Veröffentlichungstag und Bekanntmachung des Hinweises auf die Patenterteilung: **26.08.2026**
(21) Anmeldenummer: 24186430.5
(22) Anmeldetag: 04.07.2024
(51) Int. Cl.: H03M 1/12, H03C 1/52, H03C 3/40, H03M 1/64, H03M 1/20, H03D 3/00

(54) **VERFAHREN UND VORRICHTUNG ZUR WANDLUNG EINES ANALOGEN EINGANGSSIGNALS IN EIN DIGITALES AUSGANGSSIGNAL**
METHOD AND DEVICE FOR CONVERTING AN ANALOG INPUT SIGNAL INTO A DIGITAL OUTPUT SIGNAL
PROCÉDÉ ET APPAREIL POUR CONVERTIR UN SIGNAL D'ENTRÉE ANALOGIQUE EN UN SIGNAL DE SORTIE NUMÉRIQUE

(43) Veröffentlichungstag der Anmeldung: 07.01.2026
(73) Patentinhaber: Siemens Aktiengesellschaft, 80333 München (DE)
(72) Erfinder: Griessbach, Gunter, 09423 Gelenau (DE); Helmdach, Alexander, 09130 Chemnitz (DE); Prochaska, Dirk, 09127 Chemnitz (DE); Raab, Oliver, 94496 Ortenburg (DE); Weikert, Robert, 92342 Burggriesbach (DE)
(74) Vertreter: Siemens Patent Attorneys

(56) Entgegenhaltungen:
- EP-A1- 3 624 334
- ULRICH BURKHARD: "A Digital Dithering Phase Shift Modulator for Enhanced Resolution", 2024 IEEE APPLIED POWER ELECTRONICS CONFERENCE AND EXPOSITION (APEC), IEEE, 25 February 2024 (2024-02-25), pages 2849 - 2854, XP034597384, DOI: 10.1109/APEC48139.2024.10509524
- NATHAN WEST ET AL: "Increasing the resolution of a uniform quantizer using a deterministic dithering signal", AUTOTESTCON, 2012 IEEE, IEEE, 10 September 2012 (2012-09-10), pages 54 - 57, XP032256872, ISBN: 978-1-4673-0698-0, DOI: 10.1109/AUTEST.2012.6334521
- AUMALA O: "TURNING INTERFERENCE AND NOISE INTO IMPROVED RESOLUTION", MEASUREMENT, INSTITUTE OF MEASUREMENT AND CONTROL. LONDON, GB, vol. 19, no. 1, September 1996 (1996-09-01), pages 41 - 48, XP000679777, ISSN: 0263-2241, DOI: 10.1016/S0263-2241(96)00062-0

## Beschreibung

Die Erfindung betrifft ein Verfahren zur Wandlung eines analogen Eingangssignals in ein digitales Ausgangssignal, umfassend die Schritte
- das zu wandelnde analoge Eingangssignal wird einem Amplitudenmodulator mit Trägerunterdrückung eingangsseitig zugeführt, um ein trägerloses amplitudenmoduliertes Signal zu erhalten,
- zu dem von dem Amplitudenmodulator ausgegebenen, amplitudenmodulierten Signal wird in einem Addierer ein um 90° verschobenes, bevorzugt sinusförmiges Trägersignal addiert, um ein phasenmoduliertes Signal zu erhalten,
- das phasenmodulierte Signal wird einem Begrenzer zugeführt, mittels dem eine Störamplitudenmodulation in dem phasenmodulierten Signal unterdrückt wird,
- das von dem Begrenzer ausgegebene Signal wird einer Demodulationseinrichtung zugeführt und darin mit wenigstens einem Abtast-Clocksignal abgetastet.

Darüber hinaus betrifft die Erfindung eine Vorrichtung zur Wandlung eines analogen Eingangssignals in ein digitales Ausgangssignal zur Durchführung eines solchen Verfahrens.

Ein Analog-Digital-Wandler dient dazu, eine analoge Eingangsgröße in ein digitales Signal zu konvertieren. Bekannte Analog-Digital-Wandler sind z.B. der SAR-Wandler (Sukzessiv-Approximations-Wandler) und der Sigma-Delta-Wandler. Beide Wandlertypen sind mit Nachteilen verbunden, welche aus Gleichspannungsfehlern des analogen Eingangssignals resultieren. Beim Sigma-Delta-Wandler wird ein Vergleichssignal gebildet, welches analog gefiltert, d.h. rekonstruiert, wird. Sprünge des analogen Eingangssignals können daher zu Einschwingfehlern führen. Um galvanisch getrennte Eingänge zu realisieren, sind für jeden Eingangskanal vollständig getrennte A/D-Wandler erforderlich. Der SAR-Wandler weist das Problem auf, dass ein signifikantes Quantisierungsrauschen auftritt. Ferner ist für die Skalierung eine sehr genaue Amplitudenreferenz erforderlich, welche temperatur- und altersstabil ist. Eine obere Grenzfrequenz der in dem A/D-Wandler eingesetzten Komponenten beschränkt die Nutzbarkeit bei höheren Signalfrequenzen.

Um die oben genannten Probleme zu beseitigen, werden sog. Chopper-Verstärker eingesetzt. Eine galvanische Trennung wird durch getrennte Wandler mit eigenem Potential realisiert. Eine Verschiebung der oberen Grenzfrequenz ist hingegen derzeit nicht möglich. Auch genaue, stabile Referenzen zur Skalierung sind aufwändig und teuer.

Die EP 3 624 334 A1 offenbart eine weiterentwickelte Vorrichtung zur Wandlung eines analogen Eingangssignals in ein digitales Ausgangssignal. Konkret handelt es sich um einen Analog-Digital-Wandler (ADC-Wandler), der auf dem Unterschied der Phasenlage eines zur zu messenden Eingangsspannung modulierten Signals im Vergleich zu einem Referenzsignal basiert. Der aus der EP 3 624 334 A1 vorbekannte Analog-Digital-Wandler kann auch als Phasenmodulationswandler bezeichnet werden.

Der Phasenmodulationswandler gemäß der EP 3 624 334 A1 umfasst einen Amplitudenmodulator mit Trägerunterdrückung zur Bereitstellung eines trägerlosen amplitudenmodulierten Signals. Der Amplitudenmodulator weist ein Signaleingang auf, an dem ein analoges, zu wandelndes Eingangssignal zugeführt werden kann. Es ist ferner ein Addierer vorhanden, dem das von dem Amplitudenmodulator ausgegebene trägerlose amplitudenmodulierte Signal zugeführt wird und der dazu eingerichtet ist, zu diesem ein um 90° verschobenes Trägersignal zu addieren und ein phasenmoduliertes Signal bereitzustellen. Weiterhin ist ein Begrenzer vorhanden, dem das von dem Addierer ausgegebene, phasenmodulierte Signal zugeführt wird und der dazu ausgebildet ist, eine Störamplitudenmodulation in dem phasenmodulierten Signal zu unterdrücken.

Das resultierende Ausgangssignal des Begrenzers weist eine Amplitude auf, welche aus 0 oder 1 besteht. Man kann auch sagen, es liegt ein in der Amplitude digitales Signal vor. Die Länge dieser Impulse ist in Abhängigkeit der gewählten Trägerfrequenz wertkontinuierlich. Die Information steckt in der Länge der Rechteckpulse. Das Ausgangssignal des Begrenzers trägt die Modulation in zeitlich unterschiedlichen Nulldurchgängen im Vergleich zu dem 90°-Trägersignal. In diesem Zusammenhang sei auch auf die Figuren der EP 3 624 334 A1, insbesondere die darin enthaltenen Figuren 5 bis 8 nebst zugehöriger Beschreibung verwiesen, welche das Prinzip näher erläutern.

Das vom Begrenzer ausgegebene Signal, das vorliegend auch kurz als begrenztes Signal bezeichnet wird, kann anschließend abgetastet werden, wobei die Abtastung ausreichend schnell erfolgen sollte, um die Nulldurchgänge zu erfassen (Abtasttheorem).

Der aus der EP 3 624 334 A1 vorbekannte Phasenmodulationswandler hat sich prinzipiell bewährt. Es besteht jedoch teilweise Bedarf daran, hohe Auflösungen erzielen zu können.

Prinzipbedingt empfiehlt sich bei dem Phasenmodulationswandler für eine hohe Genauigkeit ein möglichst großer Unterschied zwischen der Abtastrate f_{abtast} des modulierten Eingangssignals , mit anderen Worten des begrenzten, abzutastenden Signals, im Vergleich zum Takt des Amplitudenmodulators, mit anderen Worten der Modulatorfrequenz. Diese Frequenz entspricht zweckmäßiger Weise der Frequenz des Referenzsignals, mit dem verglichen wird und kann auch als f_{referenz} bezeichnet werden.

Es gilt $N \left[Bit\right] = {log}_{2} \left(90°/360°*{f}_{abtast}/{f}_{referenz}\right) .$

Es wäre prinzipiell denkbar, für eine höhere Genauigkeit f_{referenz} zu verringern bzw. möglichst niedrig zu halten. Dies hätte jedoch den entscheidenden Nachteil, dass Filterkomponenten, die beispielsweise zum Filtern von Oberwellen aus dem Spektrum von für den Phasenmodulationswandler genutzten Rechtecksignalen, die für die Taktung des Modulators bzw. das Referenzsignal zum Einsatz kommen können, dann deutlich größer ausfallen würden. Auch gilt, dass die Datenrate des Phasenmodulationswandlers von dem Modulatorfrequenz und somit insbesondere von der Frequenz des Referenzsignals abhängt. Zu jeder vollen Periode des Referenzsignals liefert der Phasenmodulationswandler einen neuen Wert. Eine Verringerung der Frequenz des Referenzsignals würde damit den Phasenmodulationswandler auch entsprechend langsamer machen.

Bezüglich der zweiten Stellgröße - der reinen Abtastfrequenz, mit anderen Worten der Frequenz des Abtast-Clocksignals - gilt, dass diese nicht beliebig erhöht werden kann. Kommt beispielsweise eine Demodulationseinrichtung auf Basis eines FPGAs zum Einsatz, würde dies zum einen die Nutzung von vergleichsweise schnellen FPGA-Familien, mit denen in der Regel ein sehr hoher Preis einhergeht, erfordern, und zum anderen Probleme bei der Synthese und Realisierung aufgrund von nicht mehr zu schaffendem Timing Constraints führen.

Es ist daher eine Aufgabe der vorliegenden Erfindung, ein Verfahren und eine Vorrichtung der eingangs genannten Art anzugeben, welche eine verbesserte Auflösung bieten, die genannten Nachteile jedoch vermeiden oder zumindest reduzieren.

Diese Aufgabe wird bei einem Verfahren der eingangsgenannten Art dadurch gelöst, dass die Phasenlage des wenigstens einen Abtast-Clocksignals zur Erzielung einer erhöhten Auflösung dynamisch geändert wird, insbesondere um Schritte von weniger als 40°, bevorzugt um Schritte von weniger als 20°, besonders bevorzugt um Schritte von weniger als 10°.

Darüber hinaus wird die Aufgabe gelöst durch eine Vorrichtung zur Wandlung eines analogen Eingangssignals in ein digitales Ausgangssignal zur Durchführung des Verfahrens nach einem der vorhergehenden Ansprüche, umfassend
- einen Amplitudenmodulator mit Trägerunterdrückung, dem ein zu wandelndes analoges Eingangssignal eingangsseitig zugeführt werden kann, um ein trägerloses amplitudenmoduliertes Signal zu erhalten,
- einen Addierer, um zu dem trägerlosen amplitudenmodulierten Signal ein um 90° verschobenes, bevorzugt sinusförmiges Trägersignal zu addieren und ein phasenmoduliertes Signal zu erhalten,
- einen Begrenzer, dem das phasenmodulierte Signal zugeführt werden und mit dem eine Störamplitudenmodulation in dem phasenmodulierten Signal unterdrückt werden kann,
- eine Demodulationseinrichtung, der das von dem Begrenzer ausgegebene Signal zugeführt und darin mit wenigstens einem Abtast-Clocksignal abgetastet werden kann, wobei
- die Vorrichtung Mittel zur Phasenlagenänderung umfasst, die ausgebildet und/oder eingerichtet sind, um die Phasenlage des wenigstens einen Abtast-Clocksignals zur Erzielung einer erhöhten Auflösung dynamisch zu ändern, insbesondere um Schritte von weniger als 40°, bevorzugt um Schritte von weniger als 20°, besonders bevorzugt um Schritte von weniger als 10°.

Die vorliegende Erfindung basiert mit anderen Worten auf dem Grundgedanken, bei einem Phasenmodulationswandler gezielt eine dynamische Änderung der Phasenlage des genutzten Abtast-Clocksignals bzw. der genutzten Abtast-Clocksignale vorzusehen und hierdurch die Auflösung zu erhöhen. Man kann auch sagen, es erfolgt ein Stepping oder ein aktives, schrittweises Verschieben der Phase des bzw. - im Falle mehrerer - der Abtast-Clocksignale, mit anderen Worten Abtasttakte, die für die Abtastung des begrenzten Signals zum Einsatz kommen. Im Ergebnis kann die effektive Abtastrate des Phasenmodulationswandlers - gegenüber einer Variante ohne dynamische Phasenverschiebung - erhöht werden.

Ein ganz erheblicher Vorteil der vorliegenden Erfindung besteht darin, dass durch das aktive Verschieben der Phase bzw. Phasen die Auflösung erhöht werden kann, ohne dass die effektive Modulatorfrequenz abgesenkt werden müsste. Diese kann somit hoch bleiben. Es findet eine gewisse Entkopplung der Datenrate von der Modulatorfrequenz statt, was für die Hardwareschaltung vorteilhaft ist.

Als besonders vorteilhaft hat sich erwiesen, wenn die Modulatorfrequenz im Bereich von 1 MHz bis 50 MHz liegt. Dies auch, da sich in diesem Frequenzbereich Filter kompakt realisieren lassen.

Insbesondere gilt, dass die Frequenz des wenigstens einen Abtast-Clocksignals um wenigstens eine Größenordnung, bevorzugt um zwei Größenordnungen, über der Modulatorfrequenz des Amplitudenmodulators liegt. Werden mehrere Abtast-Clocksignale für die Abtastung genutzt, gilt bevorzugt, dass die Frequenz aller Abtast-Clocksignale um wenigstens eine Größenordnung, bevorzugt um zwei Größenordnungen, über der Modulatorfrequenz des Amplitudenmodulators liegt. Werden mehrere Abtast-Clocksignale für die Abtastung genutzt, weisen diese bevorzugt die gleiche Frequenz auf.

Auch sei angemerkt, dass viele Anwendungen eine (kapazitive) galvanische Trennung erfordern. Es hat sich gezeigt, dass eine solche bei einem Phasenmodulationswandler praktisch an jeder beliebigen Stelle des Signalpfades möglich ist. Wird die Auflösung auf die erfindungsgemäße Weise erhöht, können die zur Isolation nötigen Koppelkondensatoren und ggf. nachgeschaltete Filter deutlich kleiner und günstiger realisiert werden, als es der Fall bei einer Senkung der Modulatorfrequenz wäre.

In zweckmäßiger Ausgestaltung gilt, dass das zu wandelnde analoge Eingangssignal dem Amplitudenmodulator mit Trägerunterdrückung an einem Eingang zugeführt wird und dass dem Amplitudenmodulator an einem weiteren Eingang ein insbesondere rechteck- oder sinusförmiges Trägersignal zugeführt wird. Die erfindungsgemäße Vorrichtung kann entsprechend ausgebildet und/oder eingerichtet sein. Das um 90° phasenversetzte Trägersignal, was mittels des Addierers zu dem amplitudenmodulierten Signal hinzuaddiert wird, ist zweckmäßiger Weise um 90° zu demjenigen Trägersignal phasenversetzt, das dem Amplitudenmodulator zugeführt wird. Es gilt insbesondere, dass die Frequenz dieses Trägersignals der Modulatorfrequenz entspricht. Dieses Trägersignal stellt ferner insbesondere einen zu unterdrückenden Träger dar.

Mit anderen Worten gilt insbesondere, dass das phasenmodulierte Signal gebildet wird aus Amplitudenmodulation des Eingangssignales mit einem Träger und dieser Träger im Amplitudenmodulator unterdrückt wird. Das trägerlose Zweiseitenbandsignal wird mit einem 90°-Träger addiert. Nach Begrenzung dieses Signales steht ein phasenmoduliertes Signal zur Verfügung. Das Zweiseitenband-Signal enthält Seitenbänder mit jeweils gleicher Information. Durch die Erzeugung eines amplitudenmodulierten Signals mit Trägerunterdrückung entfällt die aufwändige Kompensation des in der Amplitudenmodulation enthaltenen Trägers. Durch die Addition eines neuen Trägers, welcher um 90° gegenüber dem Träger, der zu dem AM-Signal gehört, gedreht wird, erhält man ein phasenmoduliertes Signal mit maximal +/- 90° Phasenhub.

Bei dem Amplitudenmodulator mit Trägerunterdrückung kann es sich beispielsweise um einen (digitalen) Schaltermodulator, etwa Doppelgegentaktmodulator, oder auch einen (digitalen) Ringmodulator handeln. Der Schaltermodulator umfasst bevorzugt wenigsten einen insbesondere digitalen Schalter und/oder wenigstens ein mechanisches Relais und/oder wenigstens ein Reed-Relais und/oder wenigstens einen MEMS-Schalter oder ist dadurch gegeben. Die Abkürzung MEMS steht hierbei in bekannter Weise für "Micro-Electro-Mechanical Systems".

Zweckmäßiger Weise gilt, dass insbesondere ab dem Ausgang des Amplitudenmodulators und/oder bis zum Ausgang des Begrenzers bzw. Eingangs der Demodulationseinrichtung eine differentielle Signalübertragung erfolgt. Die erfindungsgemäße Vorrichtung ist in Weiterbildung entsprechend ausgestaltet. Man kann auch sagen, dass dann zumindest beginnend vom Ausgang des Amplitutenmodulators und insbesondere zumindest bis hin zum Ausgang des Begrenzers bzw. bis hin zur Demodulationseinrichtung eine differentielle Signalübertragung aufgebaut wird.

Der Addierer kann wenigstens einen Operationsverstärker umfassen oder dadurch gegeben sein. Es kann sich insbesondere um wenigstens einen volldifferentiellen Operationsverstärker handeln.

Bevorzugt wird mittels der Demodulationseinrichtung eine Flächenüberlappung zwischen dem begrenzten Signal und dem Referenzsignal berechnet, dies insbesondere über mehrere Perioden. Die Demodulationseinrichtung kann entsprechend ausgebildet und/oder eingerichtet sein.

Dass die Phasenlage des einen Abtast-Clocksignals oder der mehreren Abtast-Clocksignale dynamisch geändert wird, bedeutet insbesondere, dass die Phasenlage mehrfach, wiederkehrend, bevorzugt zyklisch, kontinuierlich bzw. quasi-kontinuierlich, verändert wird.

Aufgrund der erfindungsgemäßen aktiven, dynamischen Phasenverschiebung ändert sich die Phasenlage des - oder im Falle mehrerer insbesondere aller - Abtast-Clocksignale wiederkehrend, etwa zyklisch, in feinen Schritten. Die Veränderung erfolgt dabei insbesondere zur Laufzeit, etwa Programmlaufzeit einer für die Demodulation genutzten Demodulationseinrichtung, die wenigstens einen FPGA und/oder ASIC umfassen oder durch wenigstens einen FPGA und/oder ASIC gegeben sein kann.

Die Änderung der Phasenlage kann man auch als Verschiebung der Phasenlage bezeichnen und auffassen. Zweckmäßiger Weise gilt, dass die Änderung der Phasenlage um die jeweilige Schrittgröße immer in einer Richtung erfolgt. Sie kann insbesondere mehrfach bzw. wiederkehrend in die gleiche Richtung und mit der gleichen Schrittgröße geändert werden. Die erfindungsgemäße Änderung bzw. das "Stepping" der Phasenlage des wenigstens einen Abtast-Clocksignals kann beispielswiese alle paar Mikrosekunden erfolgen.

In vorteilhafter Weiterbildung des erfindungsgemäßen Verfahrens kann vorgesehen sein, dass die Phasenlage des wenigstens einen Abtast-Clocksignals um jeweils gleich große Schritte dynamisch geändert wird und/oder um Schritte von 360°/n dynamisch geändert wird, wobei n eine natürliche Zahl größer oder gleich 30, insbesondere größer oder gleich 40, bevorzugt größer oder gleich 50, besonders bevorzugt größer oder gleich 100 ist. Die Mittel zur Phasenlagenänderung einer erfindungsgemäßen Vorrichtung können entsprechend eingerichtet sein.

Eine weitere vorteilhafte Ausführungsform des erfindungsgemäßen Verfahrens zeichnet sich ferner dadurch aus, dass die Phasenlage des wenigstens einen Abtast-Clocksignals an mehreren aufeinanderfolgenden, insbesondere äquidistant voneinander beabstandeten Zeitpunkten geändert wird, bevorzugt, wobei zwischen den beabstandeten Zeitpunkten jeweils wenigstens eine Mikrosekunde liegt. Der zeitliche Abstand zwischen aufeinanderfolgenden Zeitpunkten der Phasenlagenänderung kann beispielsweise im Bereich von 2 bis 50 Mikrosekunden, bevorzugt im Bereich von 5 bis 50 Mikrosekunden, liegen. Die Mittel zur Phasenlagenänderung der erfindungsgemäßen Vorrichtung können entsprechend eingerichtet sein.

Auch kann vorgesehen sein, dass die Phasenlage des wenigstens einen Abtast-Clocksignals wenigstens n/m Mal um Schritte von 360°/n geändert wird. Dabei ist m eine natürliche Zahl größer oder gleich 1. Auch hier gilt, dass die Mitte zur Phasenlagenänderung der erfindungsgemäßen Vorrichtung in Weiterbildung entsprechend eingerichtet sind.

Als besonders vorteilhaft hat sich ferner erwiesen, wenn das von dem Begrenzer ausgegebene Signal in der Demodulationseinrichtung nicht nur mit einem, sondern mit mehreren zueinander phasenverschobenen Abtast-Clocksignalen abgetastet wird. Beispielsweise können zwei, drei, vier oder auch mehr Abtast-Clocksignale für die Abtastung genutzt werden. Kommen mehrere Abtast-Clocksignale zum Einsatz, gilt zweckmäßigerweise, dass diese fest zueinander phasenversetzt, mit anderen Worten phasenverschoben, sind. Der feste Phasenversatz wird dabei zweckmäßigerweise in Abhängigkeit der Anzahl der mehreren Abtast-Clocksignale gewählt. Kommen zum Beispiel vier fest zueinander phasenversetzte Abtast-Clocksignale für die Abtastung zum Einsatz, sind diese zweckmäßigerweise jeweils um 90° zueinander fest phasenversetzt. Mit anderen Worten gilt dann, dass ein zweites Abtast-Clocksignal zu dem ersten Abtast-Clocksignal fest um 90° phasenversetzt ist, dass ein drittes ein drittes Abtast-Clocksignal zu dem zweiten Abtast-Clocksignal fest um 90° phasenversetzt ist (und zu dem ersten um 180°) und dass ein viertes Abtast-Clocksignal zu dem dritten Abtast-Clocksignal fest um 90° phasenversetzt ist (und zu dem ersten um 270°), und alle vier Abtast-Clocksignale gemeinsam für die Abtastung des begrenzten Signals genutzt werden. Der feste Phasenversatz beträgt mit anderen Worten insbesondere 360°/m, wobei m der Anzahl der mehreren, für die Abtastung genutzten Clocksignale entspricht.

Kommen nur zwei zueinander fest phasenversetzte Abtast-Clocksignale zum Einsatz, sind diese zweckmäßigerweise um 180° fest zueinander phasenversetzt. Bei drei Abtast-Clocksignalen würde der feste Phasenversatz zwischen jeweils zwei Abtast-Clocksignalen zweckmäßigerweise 120° betragen.

Werden mehrere Abtast-Clocksignale für die Abtastung genutzt, werden diese zweckmäßigerweise alle auf die erfindungsgemäße Weise dynamisch in ihrer Phasenlage geändert. Die dynamische, schrittweise Phasenlagenänderung der mehreren Abtast-Clocksignale erfolgt dabei zweckmäßiger Weise jeweils synchron und/oder um gleiche große Schritte, insbesondere von weniger als 40°. Es gilt ferner zweckmäßiger Weise, dass die dynamische, schrittweise Phasenlagenänderung der mehreren Abtast-Clocksignale derart erfolgt, dass der festen Phasenversatz, den die mehreren Abtast-Clocksignale zueinander haben, aufrecht erhalten bleibt.

Die Nutzung mehrerer Abtast-Clocksignale im Rahmen der vorliegenden Erfindung bietet den Vorteil, dass die dynamische Phasenlagenänderung nur einen geringeren Bereich abdecken bzw. durchlaufen muss. Rein beispielhaft sei genannt, dass für den Fall von vier jeweils um 90° fest zueinander phasenversetzter Abtast-Clocksignale, für welche die dynamische Änderung der Phasenlagen jeweils gleichzeitig erfolgt, die Verschiebung nur einen Bereich von 90°, nicht jedoch der vollen 360° abdecken muss.

Wird die Phasenlage des einen oder der mehreren Abtast-Clocksignale wenigstens n/m Mal um Schritte von 360°/n geändert, gilt zweckmäßigerweise, dass m der Anzahl der mehreren zueinander bevorzugt fest phasenversetzten Abtast-Clocksignale entspricht, die gemeinsam für die Abtastung genutzt werden. m kann beispielsweise 2, 3, 4 oder mehr betragen.

Eine weitere besonders vorteilhafte Ausführungsform des erfindungsgemäßen Verfahrens zeichnet sich dadurch aus, dass das wenigstens eine Abtast-Clocksignal aus dem Ausgangssignal eines insbesondere spannungsgesteuerten Oszillators erzeugt wird, der Bestandteile einer Phasenregelschleife (englisch: Phase-Locked Loop, kurz PLL) ist, und dass die dynamische Änderung der Phasenlage des wenigstens einen Abtast-Clocksignals erzielt wird, indem die Phasenlage des Rückkoppelsignals für den Oszillator, welches ausgangsseitig des Oszillators abgegriffen und dem Oszillator insbesondere eingangsseitig wieder zugeführt wird, dynamisch geändert wird, insbesondere um Schritte von weniger als 40°, bevorzugt um Schritte von weniger als 20°, besonders bevorzugt um Schritte von weniger als 10°.

Bei Nutzung mehrerer Abtast-Clocksignale kann ferner vorgesehen sein, dass diese alle aus dem Ausgangssignal des einen insbesondere spannungsgesteuerten Oszillators erzeugt werden. Die dynamische Änderung der Phasenlage des Rückkoppelsignals resultiert dann jeweils in eine Änderung der Phasenlagen aller Abtast-Clocksignale synchron und um gleich große Schritte, was sich als besonders geeignete, leicht umzusetzende Variante erwiesen hat.

Es kann vorgesehen sein, dass der Oszillator wenigstens einen phasenvariablen Abgriff und bevorzugt mehrere phasenstarre Abgriffe aufweist, wobei der wenigstens eine phasenvariable Abgriff es ermöglicht, die 360° Phasenlage des Oszillators in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei der phasenvariable Abgriff mit dem Rückkoppelpfad des Oszillators verbunden ist, so dass ein von dem phasenvariablen Abgriff stammendes Signal dem Oszillator als Rückkoppelsignal, insbesondere eingangsseitig, wieder zugeführt werden kann, und die Phasenlage des von dem phasenvariable Abgriff stammenden Signals dynamisch um Schritte von 360°/n geändert wird.

Die erfindungsgemäße Vorrichtung kann sich in analoger Weise dadurch auszeichnen, dass sie, bevorzugt deren Demodulationseinrichtung, eine Takterzeugungseinrichtung zur Erzeugung des wenigstens einen Abtast-Clocksignals aufweist. Die Takterzeugungseinrichtung weist in vorteilhafter Ausgestaltung wenigstens eines, bevorzugt mehrere, Takterzeugungsmodul(e) auf oder ist dadurch gebildet. Das oder im Falle mehrerer das das jeweilige Takterzeugungsmodul kann eine Phasenregelschleife mit einem insbesondere spannungsgesteuerten Oszillator umfassen. Es kann gelten, dass der Oszillator wenigstens einen phasenvariablen Abgriff und bevorzugt mehrere phasenstarre Abgriffe aufweist, wobei der wenigstens eine phasenvariable Abgriff es ermöglicht, die 360° Phasenlage des Oszillators in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei der phasenvariable Abgriff mit dem Rückkoppelpfad des Oszillators verbunden ist, so dass ein von dem phasenvariable Abgriff stammendes Signal dem Oszillator als Rückkoppelsignal insbesondere eingangsseitig wieder zugeführt werden kann, und die Mittel zur Phasenlagenänderung ausgebildet und/oder eingerichtet sind, um die die Phasenlage des von dem phasenvariable Abgriff stammenden Signals dynamisch um Schritte von 360°/n zu ändern.

Eine Realisierung kann mit anderen Worten beispielsweise erzielt werden, indem ein Oszillator mit phasenvariablem Abgriff zum Einsatz kommt, welcher eine Unterteilung der Phasenlage in feine Schritte ermöglicht. Rein beispielhaft sei in diesem Zusammenhang verwiesen auf FPGAs (Field Programmable Gate Arrays) des Herstellers Xilinx bzw. AMD, die es in einer Ausführung mit einem Mixed-Mode Clock-Manager-Modul, kurz MMCM-Modul, gibt, das eine solche feine Unterteilung der Phase an einem phasenvariablen Abgriff bietet. Die entsprechende Funktion wird auch als "finePS" bezeichnet, was für "fine phase shift" steht. Diese Option kann im Rahmen der vorliegenden Erfindung zum Einsatz kommen, um die dynamische, schrittweise Änderung der Phasenlage(n) und damit die Auflösungserhöhung zu erzielen. Dies insbesondere, indem der phasenvariable Abgriff für das bzw. als Rückkoppelsignal für den Oszillator genutzt wird. Der Anmelderin sind zum Beispiel FPGA-Modelle von XILINX bzw. AMD bekannt, die an einem entsprechenden phasenvariablen Abgriff eine Unterteilung der Phase ("finePS") in 56 Schritte, mit anderen Worten in Schritte von 360°/n mit n = 56, ermöglicht, was sich im Rahmen der vorliegenden Erfindung für geeignet erwiesen hat. Es sei jedoch betont, dass natürlich auch eine feinere oder gröbere Unterteilung möglich ist und genutzt werden kann. Weiter beispielhaft seien FPGAs von Lattice Semiconductor genannt, insbesondere der Serie EPS, ECP5, EPC5-5G, die ebenfalls eine feine Unterteilung der Phase und zwar mit bis zu 300 Schritten ermöglichen.

Die Mittel zur Phasenlagenänderung einer erfindungsgemäßen Vorrichtung können beispielsweise durch eine insbesondere auf einem FPGA implementierte Schaltung bzw. Logik gegeben sein oder eine solche umfassen, welche die entsprechende Steuerung der dynamischen Phasenverschiebung, bzw. im Falle mehrerer Abtast-Clocksignale Verschiebungen, - insbesondere in der Variante, dass ein phasenvariabler Abgriff mit dem Oszillator-Rückkoppelpfad verbunden ist - umsetzt. Eine solche Steuerlogik kann auch zum Abgreifen/Rücksetzen eines Integrators der erfindungsgemäßen Vorrichtung dienen.

Zweckmäßigerweise gilt ferner, dass das von dem Begrenzer ausgegebene, der Demodulationseinrichtung zugeführte Signal in der Demodulationseinrichtung nach der Abtastung mit dem einen oder den mehreren Abtast-Clocksignalen in einem XOR-Modul bitweise mit einem Referenzsignal verglichen und das Ausgangssignal des XOR-Moduls integriert wird. Dann gilt weiter bevorzugt, dass jeweils solange integriert wird, bis die dynamische Änderung der Phasenlage über einen Winkelbereich von 360°/m erfolgte, wobei m eine natürliche Zahl ist, die bevorzugt der Anzahl der Abtast-Clocksignale entspricht. Die erfindungsgemäße Vorrichtung, insbesondere ein FPGA dieser, kann entsprechend eingerichtet sein.

Die erfindungsgemäße Vorrichtung kann sich in analoger Weise dadurch auszeichnen, dass sie, insbesondere deren Demodulationseinrichtung, wenigstens ein XOR-Modul und wenigstens einen dem XOR-Modul nachgeschalteten Integrator umfasst. Das XOR-Modul kann ein XOR-Gatter umfassen oder durch ein solches gegeben sein.

Bei dem Referenzsignal kann es sich insbesondere um ein solches handeln, das in der bzw. von der Demodulationseinrichtung erzeugt wird bzw. worden ist, insbesondere unter Nutzung wenigstens einer Takterzeugungseinrichtung der Demodulationseinrichtung. Das Referenzsignal wird zweckmäßiger Weise - in völliger Analogie zu dem begrenzten Signal und parallel zu diesem - ebenfalls mit dem wenigstens einen Abtast-Clocksignal abgetastet, wobei die Abtastung des Referenzsignals mit dem einen oder den mehreren Abtast-Clocksignalen zweckmäßiger Weise synchron mit der Abtastung des begrenzten Signals mit dem einen oder den mehreren Abtast-Clocksignalen erfolgt.

Weiter zweckmäßig hat sich erwiesen, wenn Abtastwerte, die in Folge der Abtastung des von dem Begrenzer ausgegebenen Signals mit dem wenigstens ein Abtast-Clocksignal vorliegen, zwischengespeichert werden. Hierfür kann beispielsweise wenigstens ein Puffer, etwa wenigstens ein FIFO-Puffer, vorhanden sein. Auch kann vorgesehen sein, dass von dem Puffer mit einer im Vergleich zu der Frequenz des wenigstens einen Abtast-Clocksignals niedrigeren Frequenz jeweils mehrere Signal-Abtastwerte ausgegeben werden können. In diesem Fall weist der Puffer einen Ausgang mit einer höheren Bitbreite auf, als sein Eingang. Rein beispielhaft sei genannt, dass eine langsamere interne Clock, auf die mittels des Puffers einsynchronisiert wird, eine Frequenz von 32 MHz hat, während das oder die Abtast-Clocksignale zur Abtastung des vom Begrenzer ausgegebenen Signals 256 MHz beträgt. Dann haben der oder die verwendeten Puffer zweckmäßigerweise eine Eingangsbreite von einem Bit und eine ausgangsbreite von 8 Bit. Andere Konstellationen und resultierende Bitverhältnisse von Ein- und Ausgang genutzter Puffer sind natürlich ebenfalls möglich.

In völlig analoger Weise können Referenzabtastwerte, die in Folge einer (insbesondere parallelen bzw. synchronen) Abtastung eines Referenzsignals mit dem wenigstens ein Abtast-Clocksignal vorliegen bzw. erhalten werden, in wenigstens einem Referenz-Puffer zwischengespeichert werden. Auch bei dem wenigstens ein Referenz-Puffer kann es sich um ein FIFO-Puffer handeln. Von dem wenigstens ein Referenz-Puffer wenn dann zweckmäßigerweise mit einer im Vergleich zu der Frequenz des wenigstens ein Abtast-Clocksignals niedrigeren Frequenz jeweils mehrere Referenz-Abtastwerte ausgegeben. Auch für das Referenzsignal wird mit anderen Worten in bevorzugter Ausgestaltung eine langsame interne Clockdomäne genutzt, auf die Mittels des bzw. der Referenz-Puffer runter- bzw. einsynchronisiert wird.

Signal-Abtastwerte und Referenz-Abtastwerte werden zweckmäßigerweise auf die gleiche langsamere interne Clockdomäne einsynchronisiert.

Kommen mehrere, zum Beispiel vier fest zueinander phasenversetzte, Abtast-Clocksignale für die Abtastung zum Einsatz, ist zweckmäßigerweise eine der Anzahl der Abtast-Clocksignale entsprechende Anzahl von Puffern, insbesondere FIFO-Puffern, vorhanden und zwar sowohl für das begrenzte Signal als auch das Referenzsignal. Werden zum Beispiel vier jeweils 90° fest zueinander phasenversetzte Abtast-Clocksignale genutzt, sind zweckmäßiger Weise acht (FIFO-)Puffer, vier für das begrenzte Signal und vier für das Referenzsignal vorhanden, mit anderen Worten vier Signal-Puffer und vier Referenz-Puffer. Entspricht m der Anzahl der genutzten Abtast-Clocksignale, sind somit bevorzugt 2m Puffer (Summe der Signal-Puffer und Referenz-Puffer) vorhanden. Dann sind weiter zweckmäßig alle Puffer mit dem XOR-Modul verbunden, um an dieses Werte für den nachfolgenden Vergleich zu übergeben.

Weiter bevorzugt gilt, dass sowohl der oder die Signal-Puffer als auch der oder die Referenz-Puffer mit der gleichen Takterzeugungseinrichtung verbunden sind und von dieser das wenigstens eine Abtast-Clocksignal erhalten.

Die von dem oder den Signal-Puffer(n) jeweils ausgegebenen mehreren Signalabtastwerte können dann einem XOR-Modul zugeführt werden, dem gleichzeitig auch von einem Referenz-Puffer ausgebebene mehrere Referenz-Abtastwerte übergeben werden und der die Sample-Abtastwerte und die Referenz-Abtastwerte miteinander vergleicht. Wird das vom Begrenzer ausgegebene Signal und das Referenzsignal, mit dem verglichen werden soll, mit dem oder den gleichen Abtast-Clocksignalen abgetastet und wird in den Puffern auf die gleiche Weise und auf die gleiche langsamere interne Clockdomäne einsynchronisiert, passt die zeitliche Reihenfolge von der Abtastung des Referenzsignals zu derjenigen des betrachtenden, begrenzten Signals.

Die erfindungsgemäße Vorrichtung kann sich entsprechend dadurch auszeichnen, dass der wenigstens ein Signal-Puffer, zweckmäßigerweise ein Ausgang dieses, mit einem Eingang des XOR-Moduls verbunden ist, und dass der wenigstens eine Referenz-Puffer, wiederum zweckmäßiger Weise ausgangsseitig, mit einem anderen Eingang des XOR-Moduls verbunden ist.

Sind zwei oder mehr Signal-Puffer vorhanden, gilt zweckmäßigerweise, dass diese alle mit dem einen Eingang des XOR-Moduls verbunden sind. Sind zwei oder mehr Referenz-Puffer vorhanden, gilt zweckmäßigerweise, dass diese alle mit dem anderen Eingang des XOR-Moduls verbunden sind.

Weiterhin kann vorgesehen sein, dass zwischen dem Amplitudenmodulator und der Demodulationseinrichtung wenigstens eine galvanische Trennung vorgesehen ist. Die oder im Falle mehrerer die jeweilige galvanische Trennung umfasst insbesondere wenigstens ein Paar von Koppelkondensatoren oder ist dadurch gegeben. Es hat sich gezeigt, dass bei einem Phasenmodulationswandler der Signalpfad an fast jeder beliebigen Stelle auf einfache Weise kapazitiv galvanisch getrennt werden kann, was einen erheblichen Vorteil darstellt. Beispielsweise kann eine galvanische Trennung, oder wenigstens ein Koppelkondensator einer solchen, zwischen dem Amplitudenmodulator und einem diesem nachgeschalteten Filter bzw. dem Addierer vorgesehen sein. Alternativ oder zusätzlich kann sich eine galvanische Trennung, oder wenigstens ein Koppelkondensator einer solchen, auch zwischen dem Addierer und dem Begrenzer befinden. Wieder alternativ oder zusätzlich kann eine galvanische Trennung, oder wenigstens ein Koppelkondensator einer solchen, zwischen dem Begrenzer und der Demodulationseinrichtung vorgesehen sein.

Eine weitere Ausführungsform zeichnet sich dadurch aus, dass wenigstens ein Signalverarbeitungsmodul vorgesehen ist bzw. wird. Dieses ist dann insbesondere dem wenigstens einen Phasenmodulationswandler vorgeschaltet. Bevorzugt gilt, dass das wenigstens eine Signalverarbeitungsmodul wenigstens einen Widerstand und/oder wenigstens eine Diode, insbesondere Zener-Diode, und/oder wenigstens einen Transistor umfasst.

Weitere Vorteile und Merkmale der vorliegenden Erfindung werden anhand der nachfolgenden Beschreibung unter Bezugnahme auf die beiliegende Zeichnung deutlich. Darin zeigt
- Figur 1: eine rein schematische Darstellung eines Ausführungsbeispiels einer erfindungsgemäßen Vorrichtung zur Wandlung eines analogen Eingangssignals in ein digitales Ausgangssignal;
- Figur 2: Takterzeugungseinrichtung, XOR-Modul, Integrator und weitere Komponenten der Demodulationseinrichtung der Vorrichtung aus Figur 1 in vergrößerter, rein schematischer Darstellung,

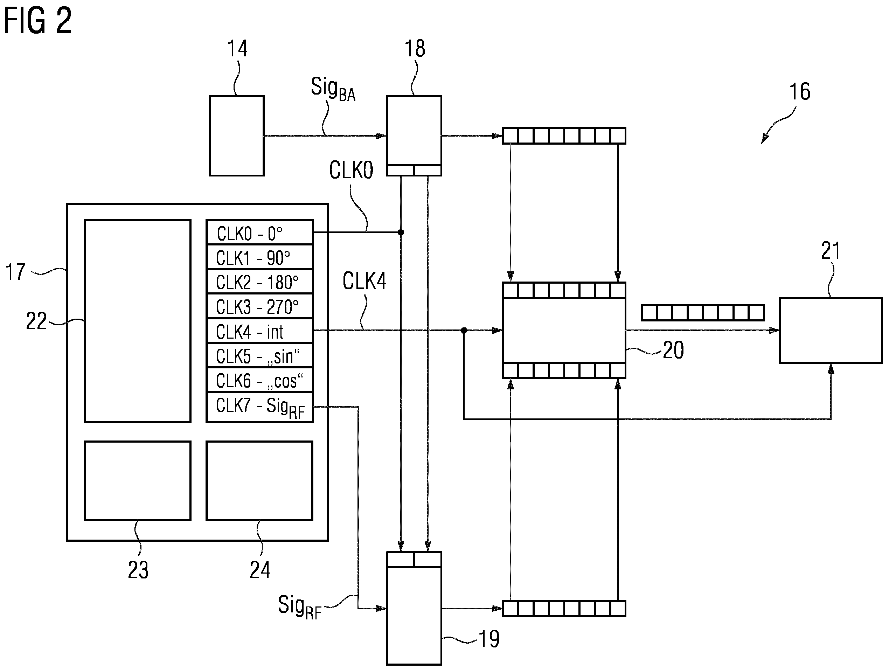

- Figur 2: Takterzeugungseinrichtung, XOR-Modul, Integrator und weitere Komponenten einer alternativ ausgestalteten Demodulationseinrichtung für die Nutzung von vier Abtast-Clocksignalen in vergrößerter, rein schematischer Darstellung, und

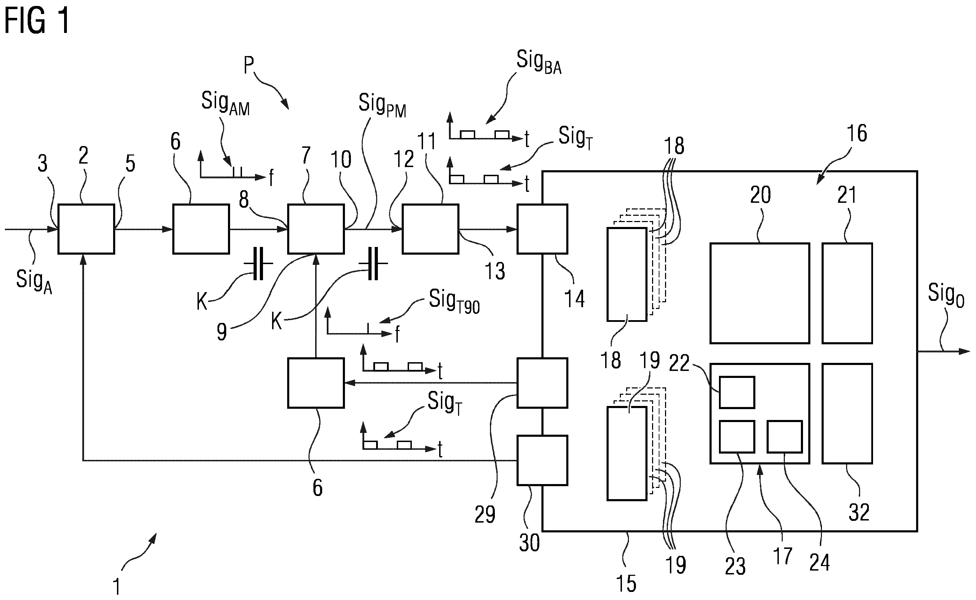

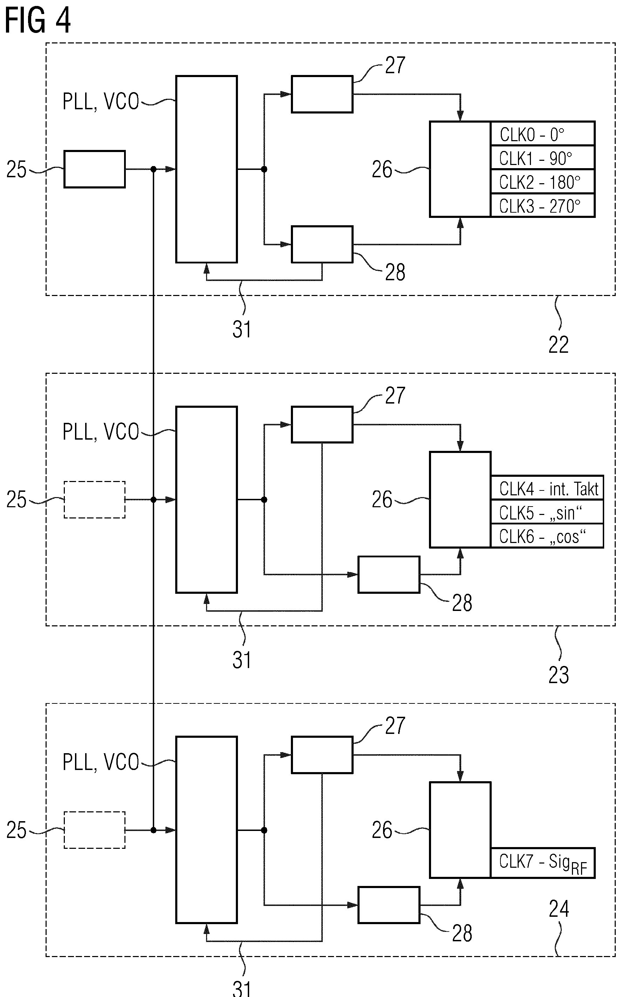

- Figur 4: die drei Takterzeugungsblöke der Takterzeugungseinrichtung der Vorrichtung aus Figur 1 in vergrößerter Darstellung.

In den Figuren sind gleiche bzw. ähnliche Elemente und Komponenten mit gleichen Bezugszeichen versehen.

Die Figur 1 zeigt in rein schematischer Blockdarstellung ein Ausführungsbeispiel einer erfindungsgemäßen Vorrichtung 1 zur Wandlung eines analogen Eingangssignal Sig_{A} in ein digitales Ausgangssignal Sig_{O}, die als Phasenmodulationswandler ausgebildet ist.

Die Vorrichtung 1 umfasst entsprechend einen Amplitudenmodulator 2 mit Trägerunterdrückung, dem das zu wandelnde analoge Signal Sig_{A} an einen Eingang 3 zugeführt wird. Der Amplitudenmodulator 2 ist ausgebildet, um aus dem analogen Eingangssignal Sig_{A}, ein trägerloses amplitudenmoduliertes Signal Sig_{AM} zu erhalten, welches mittels zwei differentieller Leitungen an die nachfolgenden Stufen übertragen wird. Es sei angemerkt, dass in den Figuren nicht beide Leitungen für die differentielle Übertragung separat dargestellt sind, sondern der Übersichtlichkeit halbe nur eine. Bei dem Amplitudenmodulator 2 kann es sich beispielswiese um einen Schaltermodulator oder einen Ringmodulator handeln. Ein Schaltermodulator kann dabei wenigsten einen insbesondere digitalen Schalter und/oder wenigstens ein mechanisches Relais und/oder wenigstens ein Reed-Relais und/oder wenigstens einen MEMS-Schalter umfassen oder dadurch gegeben sein.

An einem zweiten Eingang 4 wird dem Amplitudenmodulator 2 ein rechteck- oder sinusförmiges Trägersignal Sig_{T} zugeführt, auf dessen Erzeugung weiter unten noch näher eingegangen wird. Aus dem Ausgang 5 des Amplitudenmodulators 2 tritt das amplitudenmodulierte Signal Sig_{AM} als differentielles Signal aus.

Das amplitudenmodulierte Signal Sig_{AM} passiert anschließend einen dem Amplitudenmodulator 2 nachgeschalteten analogen Filter 6 und wird einem wiederum nachgeschalteten Addierer 7 der Vorrichtung 1 über dessen Eingang 8 zugeführt. An einem weiteren Eingang 9 wird dem Addierer 7 ein weiteres rechteckförmiges oder sinusförmiges Trägersignal Sig_{T90} zugeführt, das um 90° zu dem sinusförmigen Trägersignal Sig_{T} phasenverschoben ist. Durch Addition des trägerlosen amplitudenmodulierten Signals Sig_{AM} und des sinusförmigen Trägersignals Sig_{T90} wird ein phasenmoduliertes Signal Sig_{PM} mit Störamplitudenmodulation erhalten.

Das Signal Sig_{PM} wird an einem Ausgang 10 des Addierers 7 ausgegeben und einem Begrenzer 11 über dessen Eingang 12 zugeführt. Der Begrenzer 11 ist dazu ausgebildet, eine Störamplitudenmodulation in dem Signal Sig_{PM} zu unterdrücken. Das erhaltene Signal Sig_{BA}, das vorliegend auch als begrenztes Signal bezeichnet wird, tritt an dem Ausgang 13 des Begrenzers 11 aus.

Das Signal Sig_{BA} trägt die Modulation nun in zeitlich unterschiedlichen Nulldurchgängen im Vergleich zu dem 90°-Trägersignal Sig_{T90} bzw. dem unterdrückten Trägersignal Sig_{T}. Dies ist in Figur 1 oben rechts des Begrenzers 11 rein schematisch dargestellt. Zu erkennen sind, jeweils in einem Graphen über der Zeit dargestellt, das Signal Sig_{BA} (oben) und das Signal Sig_{T} (unten) sowie der zeitliche Versatz Δt. Die Amplitude des Signals Sig_{BA} schwankt zwischen 0 und 1, d.h. man hat ein in der Amplitude digitales Signal erhalten.

Das begrenzte Signal Sig_{BA} wird einem Eingang 14 eines digitalen Schaltungsteils 15 zugeführt, welches der Demodulation des Signals Sig_{BA} und optional weiteren Zwecken dient. Es sei angemerkt, dass, auch wenn in Figur 1 zwischen dem Bregenzer 11 und dem digitalen Schaltungsteil 15 keine weiteren Komponenten gezeigt sind, keineswegs ausgeschlossen ist, dass solche vorhanden sind. Das begrenzte Signal Sig_{BA} kann dem digitalen Schaltungsteil 15 mit anderen Worten direkt oder auch über weitere Komponenten, die auch eine weitere Verarbeitung des Signals bedingen können, zugeführt werden.

Weiterhin sei angemerkt, dass beispielsweise zwischen dem analogen Filter 6 und dem analogen Addierer 7 sowie zwischen dem Addierer 7 und dem Begrenzer 11 jeweils ein Koppelkondensator K vorgesehen sein kann, was in Figur 1 entsprechend angedeutet ist. Das Paar von Koppelkondensatoren K dient der galvanischen Trennung bzw. bildet eine solche, die im Falle eines Phasenmodulationswandlers 1 sehr einfach und quasi an beliebiger Stelle in dem Signalpfad P bis zum digitalen Schaltungsteil 15 vorgesehen sein kann, was einen erheblichen Vorteil des Phasenmodulationswandlers 1 darstellt.

Das digitale Schaltungsteil 15 kann wenigstens einen FPGA und/oder ASIC umfassen oder durch wenigstens einen FPGA und/oder ASIC gegeben sein. Bei dem hier dargestellten Ausführungsbeispiel ist das digitale Schaltungsteil durch einen FPGA 15 gegeben.

Auf dem FPGA 15 ist eine Demodulationseinrichtung 16 der Vorrichtung 1 implementiert, mittels derer eine digitale Demodulation des begrenzten Signals Sig_{BA} erfolgen kann. Die Demodulationseinrichtung 16 kann auch als digitaler Demodulator bezeichnet werden.

Im Rahmen der Demodulation erfolgen unter anderem eine Abtastung des Signals Sig_{BA} mittels wenigstens einem Abtast-Clocksignal CLK0-CLK3, ein Vergleich mit einem ebenfalls mit dem wenigstens einen Abtast-Clocksignal abgetasteten Referenzsignal Sig_{RF} und eine Integration des Vergleichs. Auf die Erzeugung des Referenzsignals Sig_{RF} und den Vergleich wird weiter unten noch näher eingegangen.

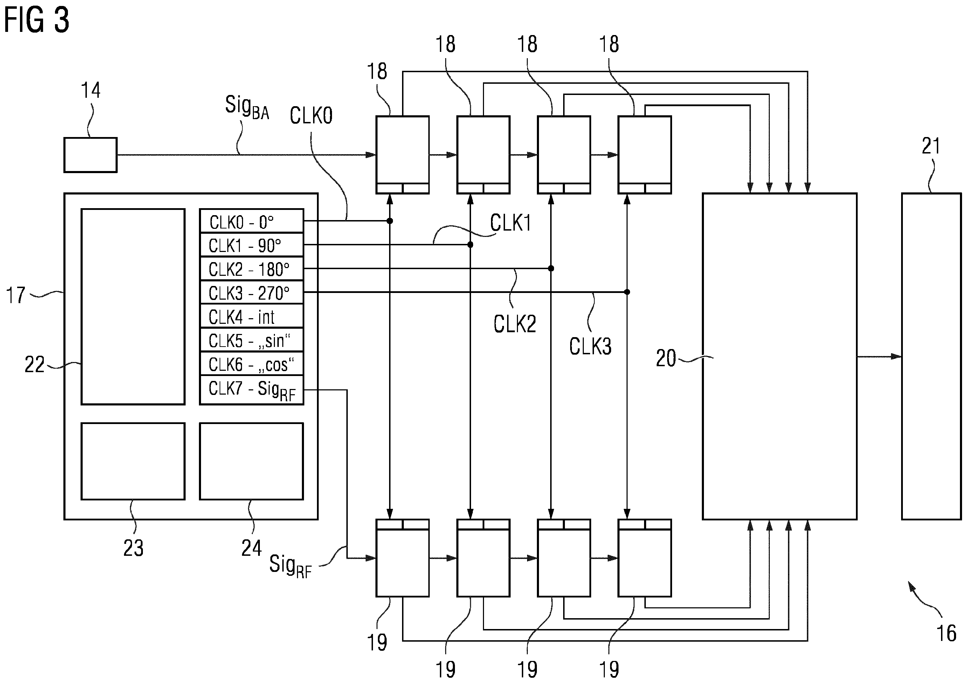

Die Figur 2 erhält eine rein schematische Blockdarstellung zu der digitalen Demodulation unter Verwendung der Demodulationseinrichtung 16 und zwar für den Fall, dass eine Abtastung mit einem Abtast-Clocksignal CLK0 erfolgt. Die Figur 3 zeigt eine alternatives Ausführungsbeispiel zur Nutzung mehrerer Abtast-Clocksignale für die Abtastung, hier beispielhaft von vier Abtast-Clocksignalen CLK0-CLK3.

Die Demodulationseinrichtung 16 umfasst eine Takterzeugungseinrichtung 17 und wenigstens einen Puffer 18 für das begrenzte Signal Sig_{BA}, der bevorzugt durch einen FIFO-Puffer gegeben ist, und vorliegend als Signal-Puffer 18 bezeichnet wird. Es ist ferner wenigstens ein weiterer Puffer 19 für das Referenzsignal Sig_{RF} vorgesehen, der ebenfalls bevorzugt als FIFO-Puffer ausgebildet ist, und zur Unterscheidung gegenüber dem Puffer 18 für das Signal Sig_{BA} als Referenz-Puffer 19 bezeichnet wird. Es sei angemerkt, dass trotz dieser verschiedenen Bezeichnungen der wenigstens eine Signal-Puffer 18 und der wenigstens eine Referenz-Puffer 19 baugleich ausgebildet sein können und vorliegend baugleich ausgebildet sind.

Die Anzahl der Signal-Puffer 18 und die Anzahl der Referenz-Puffer 19 stimmt zweckmäßiger Weise überein und entspricht jeweils der Anzahl der verwendeten Abtast-Clocksignale CLK0-CLK3. Die in Figur 2 gezeigte Demodulationseinrichtung 16 umfasst somit genau einen Signal-Puffer 18 und genau einen Referenz-Puffer 19,.

Die Figur 3 zeigt beispielhaft, dass vier Abtast-Clocksignale CLK0-CLK3 zur Abtastung des begrenzten Signals Sig_{BA} und gleichzeitig des Referenzsignals Sig_{RF} genutzt werden können. Die Demodulationseinrichtung 16 aus Figur 3 umfasst entsprechend vier, bevorzugt baugleiche, Signal-Puffer 18 und vier, bevorzugt baugleiche, Referenz-Puffer 19. In Figur 1 sind die Puffer 18, 19 aus Gründen der Übersichtlichkeit hintereinander dargestellt und der vorderste Puffer 18, 19 ist mit durchgezogener Linie gezeichnet, während die dahinterliegenden Puffer 18, 19 mit gestrichelter Linie dargestellt sind, um zu verdeutlichen, dass diese optional zusätzlich vorhanden sein können.

Den Puffern 18, 19 nachgeschaltet und mit den Ausgängen der Puffer 18, 19 verbunden ist ein XOR-Modul 20, welches ein XOR-Gatter umfassen oder durch ein solches gegeben sein kann. Konkret gilt, dass der Ausgang des wenigstens einen Signal-Puffers 18 mit einem Eingang des XOR-Moduls 20 und der Ausgang des wenigstens einen Referenz-Puffers 19 mit dem anderen Eingang des XOR-Moduls 20 verbunden ist, so dass ausgegebene Werte an dieses übergeben und verglichen werden können. Bei dem Ausführungsbeispiel aus Figur 3 sind die Ausgänge aller vier Signal-Puffer 18 mit dem einen Eingang des XOR-Moduls 20 und die Ausgänge aller vier Referenz-Puffer 19 mit dem anderen Eingang des XOR-Moduls 20 verbunden.

Darüber hinaus ist ein dem XOR-Modul 20 nachgeschalteter Integrator 21 vorhanden, mittels dem von dem XOR-Modul 20 ausgegebene Werte integriert werden können.

Bei dem in den Figuren 2 und 3 dargestellten Ausführungsbeispiel umfasst die Takterzeugungseinrichtung 17 der Demodulationseinrichtung 16 insgesamt drei Taktblöcke 22, 23, 24. Mittels dieser drei Taktblöcke 22, 23, 24 werden insgesamt sieben Clocksignale CLK0-CLK7 erzeugt, auch die für die Abtastung genutzten Abtast-Clocksignale CLK0 (Fig. 2) bzw. CLKO-CLK3 (Fig. 3). Es sei angemerkt, dass die Taktblöcke 22, 23, 24 auch als Taktmodule bezeichnet werden können.

Jeder der Taktblöcke 22-24 umfasst dabei eine Phasenregelschleife PLL mit einem spannungsgesteuerten Oszillator VCO. Der interne Aufbau der drei Taktblöcke 22 bis 24 ist - wiederum stark vereinfacht und rein schematisch - in der Figur 4 gezeigt. Hier sind die Phasenregelschleife PLL mit dem spannungsgesteuerten, internen Oszillator VCO des jeweiligen Taktblocks 22-24 vereinfacht als ein Blockelement dargestellt.

Der interne Oszillator VCO jedes Taktblocks 22-24 wird auf ein externes Referenzsignal von einer externen Taktquelle 25, die beispielsweise durch einen Quarzresonator gegeben sein kann, mit einem entsprechend eingestellten Faktor auf eine höhere innere Frequenz f_{VCO} ausgeregelt. Die drei Taktblöcke 22-24 können von der gleichen externen Taktquelle 25 versorgt werden, was jedoch nicht zwingend der Fall sein muss.

Die Taktblöcke 22-24 können zum Beispiel jeweils durch ein Mixed-Mode Clock-Manager (kurz MMCM) Modul bzw. Block gegeben sein oder ein solches bzw. einen solchen umfassen. Die Hersteller Xilinx bzw. AMD beispielswiese bieten FPGAs mit solchen Modulen bzw. Blöcken an.

Jeder der Taktblöcke 22 bis 24 hat mehrere Clockausgänge, die in der Figur 4 durch ein mit der Bezugsziffer 26 versehenes Blockelement angedeutet sind. Jeder Clockausgang kann verschiedene Teiler - und somit Frequenzen - und verschieden fest definierte Phasenlagen annehmen. Alle Takte werden dabei aus f_{VCO} abgeleitet. Neben dem die Clockausgänge repräsentierenden Blockelement 26 stehen die von dem jeweiligen Taktblock 22-24 in dem gezeigten Ausführungsbeispiel erzeugten und ausgegebenen Clocksignale CLK0-CLK7. Die entsprechende Nummerierung CLK0 bis CLK7 findet sich auch in den Figuren 2 und 3, dies nebst Pfeilen zu deren konkreter Nutzung, worauf noch eingegangen wird. Jeder Taktblock 22-24 bzw. dessen Oszillator VCO hat sowohl phasenstarre Abgriffe 27 als auch wenigstens einen phasenvariable Abgriff 28. Der phasenvariable Abgriff 28 ermöglicht eine Unterteilung der Phasenlage in feine Schritte. Bei den hier dargestellten Ausführungsformen kann eine Unterteilung in 56 Schritte erfolgen, mit anderen Worten in Schritte von 360°/n mit n = 56. Die Anzahl von 56 Schritte ist dabei beispielhaft zu verstehen.

Der Taktblock 22 kommt zum Einsatz, um die schnellen Abtasttakte, mit anderen Worten Abtast-Clocksignale, für die Abtastung sowohl des begrenzten Signals Sig_{BA}, als auch des Referenzsignales Sig_{RF} bereitzustellen. Bei dem Beispiel gemäß Figur 2 handelt es sich um das Abtast-Clocksignal CLK0, bei demjenigen gemäß Figur 3 um die Abatst-Clocksignale CLKO-CLK3.

Rein beispielshaft für eine Frequenz der für die Abtastung genutzten schnellen Abtast-Clocksignale CLK0-CLK3, die aus f_{VCO} abgeleitet wird, sei 256 MHz genannt. f_{VCO} kann beispielsweise 1024 MHz betragen. Selbstverständlich sind auch andere Frequenzen möglich. Zweckmäßiger Weise gilt, dass die Frequenz des (jeweiligen) Abtast-Clocksignals CLKO-CLK3 um wenigstens eine Größenordnung, bevorzugt um zwei Größenordnungen, über der Modulatorfrequenz des Amplitudenmodulators 2 liegt.

Der zweite Taktblock 23 dient der Erzeugung von langsamen internen Signalen. Dieser erzeugt bei dem dargestellten Ausführungsbeispiel die Clocksignale CLK4, CLK5 und CLK6. CLK4 ist ein langsamerer interner Takt, der vorliegend 32 MHz beträgt, was wiederum beispielhaft zu verstehen ist, und der für die Puffer 18, 19 sowie das XOR-Modul 20 und den Integrator 21 genutzt wird, was in der Figur 2 durch entsprechende Pfeile angedeutet ist. CLK5 entspricht einem Rechteck- oder Sinussignal. CLK6 einem um 90° zu dem Rechteck- bzw. Sinussignal versetzten Signal, also insbesondere einem Cosinussignal. Das Rechteck- bzw. Sinussignal wird über einen Ausgang 29 des FPGAs 15 in Richtung des Addierers 7 ausgeben, um Sig_{T90} zu erhalten und dem Eingang 9 des Addierers 7 zuzuführen. Über einen Ausgang 30 des FPGAs 15 wird das Cosinussignal als Sig_{T} in Richtung des Amplitudenmodulators 2, konkret dessen Eingang 4, ausgegeben. Es sei angemerkt, dass sich zwischen dem Ausgang 29 des FPGAs 15 und dem Eingang 9 des Addierers 7 noch ein analoger Filter 6 befindet. Zwischen dem Ausgang 30 des FPGAs 15 und dem Eingang 4 des Amplitudenmodulators 2 ist eine solcher hingegen nicht eingezeichnet, wenngleich auch nicht ausgeschlossen ist, dass sich hier ebenfalls ein solcher befindet.

Der dritte Taktblock 24 dient der Erzeugung von CLK7, was dem Referenzsignal Sig_{RF} entspricht bzw. zu dessen Erzeugung genutzt wird. Es handelt sich um ein rein internes Signal, welches den FPGA 15 nicht verlässt.

Die drei Taktblöcke 22-24 können von ihrem Aufbau her im Wesentlichen übereinstimmen. Ein Unterschied zwischen dem Taktblock 22 und den Blöcken 23 und 24 besteht jedoch darin, dass der Rückkoppelpfad 31 der Phasenregelschleife PLL bzw. von deren Oszillator VCO mit dem phasenvariablen Abgriff 28 des Oszillators VCO verbunden ist, während bei den Taktmodulen 23 und 24 der Rückkoppelpfad 31 mit einem phasenstarren Abgriff 27 verbunden ist (vgl. Figur 4).

Im Betrieb der Vorrichtung dient im Falle von Fig. 2 der eine Signal-Puffer 18 zur Abtastung des begrenzten Signals Sig_{BA} mit dem schnellen Abtast-Clocksignal CLK0 bzw. dienen im Falle von Fig. 3 die vier Signal-Puffer 18 der Abtastung des begrenzten Signals Sig_{BA} mit den vier fest zueinander phasenversetzten schnellen Abtast-Clocksignalen CLK0-CLK3 sowie der Einsynchronisierung auf die langsamere interne Clockdomäne. Dem (jeweiligen) Signal-Puffer 18 wird eingangsseitig das begrenzte Signal Sig_{BA} zur Abtastung zugeführt. Der (jeweilige) Signal-Puffer 18 erhält sowohl eines der schnellen Abtast-Clocksignale CLK0-CLK3 zur Abtastung, dies von dem Taktblock 22, als auch das langsamere interne Clocksignal CLK4, auf welches mittels des (jeweiligen) Signal-Puffers 18 einsynchronisiert wird, die von dem Taktblock 23. Es sei angemerkt, dass in der Figur 3 zur Nutzung der mehreren Abtast-Clocksignale CLK0-CLK3 und zugehöriger Puffer 18, 19 die Pfeile zu dem langsameren internen Takt CLK4 aus Gründen der Übersichtlichkeit nicht zusätzlich eingezeichnet sind.

Der (jeweilige) Signal-Puffer 18 hat einen Eingang mit einer Bitbreite von 1 und einen Ausgang mit einer Bitbreite von 8. Das Verhältnis der Bitbreiten vom Eingang zum Ausgang des (jeweiligen) Signal-Puffers 18 wird analog zum Verhältnis der Takte CLKi/CLK4, mit i = 0, 1, 2, 3, gewählt oder umgekehrt. Bei dem hier beschriebenen Beispiel gilt die CLKi/CLK4 = 256 MHz/32 MHz = 8, mit i = 0, 1, 2, 3.

Immer, wenn 8 Abtastwerte in einem Signal-Puffer 18 "aufgelaufen" sind, werden diese mehreren Werte von dem Signal-Puffer 18 ausgegeben und zwar an das XOR-Modul 20. Die Ausgabe erfolgt mit dem langsameren Takt von CLK4, also vorliegend 32 MHz. Man kann auch sagen, der (jeweilige) Signal-Puffer 18 liefert als Ausgang das "abgesamplete" digitale begrenzte Signal Sig_{BA} in zeitlich richtiger Reihenfolge.

Für den (jeweiligen) Referenz-Puffer 19 gilt das vorstehende völlig analog mit dem Unterschied, dass diesen nicht das begrenzte Signal Sig_{BA}, sondern das Referenzsignal Sig_{RF} zur Abtastung mit dem (jeweiligen) schnellen Abatst-Clocksignal CLK0-CLK3 und zur Einsynchronisierung auf CLK4 zugeführt wird, wie in den Figuren 2 und 3 schematisch durch zugehörige Pfeile angedeutet.

Von dem (jeweiligen) Referenz-Puffer 19 wird somit das "abgesamplete" digitale Referenzsignal erhalten, welches mit gleichem Clocksignal CLK0 bzw. mit gleichen Clocksignalen CLK0-CLK3 eingetaktet ist. Damit passt die zeitliche Reihenfolge zum "abgesampleten" begrenzten Sig_{BA} Signal, das von dem oder den Signal-Puffern 18 erhalten wird.

Bei der Variante gemäß Figur 3 mit den vier Abtast-Clocksignalen CLK0-CLK3 gibt dabei jeder Signal-Puffer 18 einen anderen Teil des Signals aus. Jede CLK-Abtastdomäne liefert einen Datenblock. In der gleichen Domäne wird passend dazu das Referenzsignals Sig_{RF} "abgetastet". Im XOR-Modul 20 ist dann ein Vergleich "Blockweise" möglich.

Zur Erzielung einer erhöhten Auflösung ist im Rahmend der Abtastung vorgesehen, dass die Phasenlage des einen Abtast-Clocksignals CLK0 (Figur 2) bzw. der mehreren Abast-Clocksignale CLK0-CLK3 (Figur 3), die für die Abtastung des begrenzten Signals Sig_{BA} und des Referenzsignals Sig_{RF} genutzt werden, dynamisch geändert wird. Der Rückkoppelpfad 31 des Taktblockes 22 für die Erzeugung der schnellen Abast-Clocksignale CLK0-CLK3 ist hierfür, wie oben erwähnt, mit dem phasenvariablen Abgriff 28 des Oszillators VCO verbunden.

Es wird kontinuierlich bzw. wiederholend die Phasenlage des über den Rückkoppelpfad 31 dem Oszillator VCO rückgeführten Signals geändert. Dies erfolgt bevorzugt zyklisch beispielsweise alle paar Mikrosekunden, etwa alle 42 Mikrosekunden. Die Verschiebung der Phasenlage erfolgt dabei jeweils um Schritte von 360°/56 und in die gleiche Richtung. Es ist eine Logik 32 vorgesehen (vgl. Figur 1), welche bevorzugt auf dem FPGA 15 implementiert ist, welcher auch die Demodulationseinrichtung 16 umfasst oder bildet, und welche die entsprechende Steuerung für die dynamische Phasenlagenänderung der Abtast-Clocksignale umsetzt. Die Logik 32 kann Bestandteil der Demodulationseinrichtung 16 sein.

Da bei dem Ausführungsbeispiel gemäß Figur 3 die mehreren Abtast-Clocksignale CLKO-CLK3 alle aus dem Ausgangssignal des einen Oszillators VCO des Taktblocks 22 erzeugt werden, resultiert die wiederholte Änderung der Phasenlage des Rückkoppelsignals in eine wiederholte Änderung der Phasenlagen aller für die Abtastung genutzter Abtast-Clocksignale CLK0-CLK3 synchron und um gleich große Schritte.

Durch das Stepping des Feedbacksignals über den Rückkoppelpfad 31 ändert sich mit die Phasenlage aller CLK-Ausgänge des Taktmoduls 22 synchron zu jedem Phasenschritt des Oszillators VCO. Die einzelnen Abtast-Clocksignale CLK0-CLK3 können zusätzlich weiterhin starr um 90° zueinander versetzt sein.

Im beschriebenen Fall entspricht ein Phasenschritt von ${t}_{STEP} = 1 / \left(768MHz*56\right) = 1 / 43 , 008 GHz = 23 , 25 ps .$

Durch die 90° zueinander versetzten 256MHz Abtasttakte CLK0-CLK3 muss nur eine Phasendifferenz von ${t}_{diff} = 1 / \left(256MHz*4\right) = 976 , 56 ps$ überbrückt werden, um alle möglichen diskreten Abtastpunkte mittels des feinschrittingen Phasensteppings abzudecken. Im FPGA 15 werden 42 (976,56ps/23,25ps) Perioden der Modulatorfrequenz aufsummiert.

Die rechnerische Auflösung ergibt sich zu $log 2 \left(90°/360°*43008MHz/1MHz\right) = 13 , 39 Bit$ ohne die Frequenz des Amplitudenmodulators 2 zu ändern.

Die Datenrate reduziert sich von 1MHz auf 1MHz/42 = 23,8kHz.

Ohne die dynamische Phasenverschiebung ergäbe sich hingegen eine rechnerische Auflösung von $log 2 \left(90°/360°*4*256MHz/1MHz\right) = 8 Bit .$

Mittels des den Puffern 18, 19 nachgeschalteten XOR-Moduls 20 wird im Anschluss an die schnelle Abtastung und der Einsynchronisierung festgestellt, zu welchen Zeitpunkten das begrenztes Signal Sig_{BA} und das Referenzsignal Sig_{RF} unterschiedlich sind. Die anschließende Integration mittels des Integrators 21 ergibt den gewandelten Wert, der als Sig_{O} von dem FPGA 15 ausgegeben wird (vgl. Fig. 1).

Zweckmäßiger Weise wird jeweils so lange integriert, bis die vorstehend beschriebene dynamische Änderung der Phasenlage der Abtast-Clocksignale CLK0-CLK3 über einen Winkelbereich von 360°/m erfolgte, wobei m der Anzahl der für die Abtastung von dem begrenztem Signal Sig_{BA} genutzten Abtast-Clocksignale entspricht. Die erfindungsgemäße Vorrichtung 1, insbesondere deren Demodulationseinrichtung 16 bzw. ein FPGA 15 der Vorrichtung, kann entsprechend eingerichtet sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Verfahren zur Wandlung eines analogen Eingangssignals (Sig_{A}) in ein digitales Ausgangssignal (Sig_{O}), umfassend die Schritte
- das zu wandelnde analoge Eingangssignal (Sig_{A}) wird einem Amplitudenmodulator (2) mit Trägerunterdrückung eingangsseitig zugeführt, um ein trägerloses amplitudenmoduliertes Signal (Sig_{AM}) zu erhalten,
- zu dem von dem Amplitudenmodulator (2) ausgegebenen, amplitudenmodulierten (Sig_{AM}) Signal wird in einem Addierer (7) ein um 90° verschobenes, bevorzugt sinusförmiges Trägersignal (Sig_{T90}) addiert, um ein phasenmoduliertes Signal (Sig_{PM}) zu erhalten,
- das phasenmodulierte Signal (Sig_{PM}) wird einem Begrenzer (11) zugeführt, mittels dem eine Störamplitudenmodulation in dem phasenmodulierten Signal (Sig_{PM}) unterdrückt wird,
- das von dem Begrenzer (11) ausgegebene Signal (Sig_{BA}) wird einer Demodulationseinrichtung (16) zugeführt und darin mit wenigstens einem Abtast-Clocksignal (CLKO-CLK3) abgetastet,
**dadurch gekennzeichnet, dass**
- die Phasenlage des wenigstens einen Abtast-Clocksignals (CLK0-CLK3) zur Erzielung einer erhöhten Auflösung dynamisch geändert wird, insbesondere um Schritte von weniger als 40°, bevorzugt um Schritte von weniger als 20°, besonders bevorzugt um Schritte von weniger als 10°.

2. Verfahren nach Anspruch 1,
**dadurch gekennzeichnet, dass**
die Phasenlage des wenigstens einen Abtast-Clocksignals (CLK0-CLK3) um jeweils gleich große Schritte dynamisch geändert wird und/oder um Schritte von 360°/n dynamisch geändert wird, wobei n eine natürlich Zahl größer oder gleich 30, insbesondere größer oder gleich 40, bevorzugt größer oder gleich 50, besonders bevorzugt größer oder gleich 100 ist.

3. Verfahren nach Anspruch 1 oder 2,
**dadurch gekennzeichnet, dass**
die Phasenlage des wenigstens einen Abtast-Clocksignals (CLK0-CLK3) an mehreren aufeinanderfolgenden, insbesondere äquidistant voneinander beabstandeten Zeitpunkten geändert wird, bevorzugt, wobei zwischen den beabstandeten Zeitpunkten jeweils wenigstens eine Mikrosekunde liegt.

4. Verfahren nach einem der vorhergehenden Ansprüche,
**dadurch gekennzeichnet, dass**
die Phasenlage des wenigstens einen Abtast-Clocksignals (CLK0-CLK3) wenigstens n/m Mal um Schritte von 360°/n geändert wird, wobei m eine natürliche Zahl größer oder gleich 1 ist.

5. Verfahren nach einem der vorhergehenden Ansprüche,
**dadurch gekennzeichnet, dass**
das von dem Begrenzer (11) ausgegebene Signal (Sig_{BA}) in der Demodulationseinrichtung (16) mit mehreren, insbesondere vier, jeweils um 90° zueinander bevorzugt fest phasenversetzten Abtast-Clocksignalen (CLK0-CLK3) abgetastet wird, und die Phasenlagen aller Abtast-Clocksignale (CLK0-CLK3) zur Erzielung einer Auflösungserhöhung dynamisch geändert wird, wobei die Phasenlagenänderung der mehreren Abtast-Clocksignale bevorzugt jeweils synchron und/oder um gleich große Schritte, insbesondere von weniger als 40°, erfolgt.

6. Verfahren nach Anspruch 4 und 5,
**dadurch gekennzeichnet, dass**
m der Anzahl der mehreren zueinander bevorzugt fest phasenversetzten Abtast-Clocksignale (CLK0-CLK3) entspricht, bevorzugt vier beträgt.

7. Verfahren nach einem der vorhergehenden Ansprüche,
**dadurch gekennzeichnet, dass**
das wenigstens eine Abtast-Clocksignal (CLK0-CLK3) aus dem Ausgangssignal eines insbesondere spannungsgesteuerten Oszillators (VCO) erzeugt wird, der Bestandteile einer Phasenregelschleife (PLL) ist, und die dynamische Änderung der Phasenlage des wenigstens einen Abtast-Clocksignals (CLK0-CLK3) erzielt wird, indem die Phasenlage eines Rückkoppelsignals für den Oszillator (VCO), welches ausgangsseitig des Oszillators (VCO) abgegriffen und dem Oszillator (VCO) insbesondere eingangsseitig wieder zugeführt wird, dynamisch geändert wird, insbesondere um Schritte von weniger als 40°, bevorzugt um Schritte von weniger als 20°, besonders bevorzugt um Schritte von weniger als 10°.

8. Verfahren nach Anspruch 4 und 7,
**dadurch gekennzeichnet, dass**
die mehreren Abtast-Clocksignale(CLK0-CLK3) aus dem Ausgangssignal des einen insbesondere spannungsgesteuerten Oszillators (VCO) erzeugt werden, und die dynamische Änderung der Phasenlage des Rückkoppelsignals jeweils in eine Änderung der Phasenlagen aller Abtast-Clocksignale (CLK0-CLK3) synchron und mit gleich großen Schritten resultiert .

9. Verfahren nach Anspruch 7 oder 8,
**dadurch gekennzeichnet, dass**
der Oszillator (VCO) wenigstens einen phasenvariablen Abgriff (28) und bevorzugt mehrere phasenstarre Abgriffe (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei der phasenvariable Abgriff (28) mit dem Rückkoppelpfad des Oszillators (VCO) verbunden ist, so dass ein von dem phasenvariable Abgriff (28) stammendes Signal dem Oszillator (VCO) als Rückkoppelsignal insbesondere eingangsseitig wieder zugeführt werden kann, und die Phasenlage des von dem phasenvariable Abgriff (28) stammenden Signals dynamisch um Schritte von 360°/n geändert wird.

10. Verfahren nach einem der vorhergehenden Ansprüche,
**dadurch gekennzeichnet, dass**
in der Demodulationseinrichtung (16) eine Flächenüberlappung zwischen dem von dem Begrenzer (11) ausgegebenen, der Demodulationseinrichtung (16) zugeführten Signal (Sig_{BA}) und einem Referenzsignal berechnet wird, insbesondere über mehrere Perioden.

11. Verfahren nach einem der vorhergehenden Ansprüche,
**dadurch gekennzeichnet**, dassdas von dem Begrenzer (11) ausgegebene, der Demodulationseinrichtung (16) zugeführte Signal (Sig_{BA}) in der Demodulationseinrichtung (16) nach der Abtastung mit dem wenigstens einen Abtast-Clocksignal (CLK0-CLK3) in einem XOR-Modul (20) bitweise mit einem Referenzsignal (Sig_{RF}) verglichen und das Ausgangssignal des XOR-Moduls (20) integriert wird, bevorzugt, wobei jeweils so lange intergiert wird, bis die dynamische Änderung der Phasenlage über einen Winkelbereich von 360°/m erfolgte, wobei m eine natürlich Zahl ist, die der Anzahl der Abtast-Clocksignale (CLK0-CLK3) entspricht.

12. Vorrichtung (1) zur Wandlung eines analogen Eingangssignals (Sig_{A}) in ein digitales Ausgangssignal (Sig_{O}) zur Durchführung des Verfahrens nach einem der vorhergehenden Ansprüche, umfassend
- einen Amplitudenmodulator (2) mit Trägerunterdrückung, dem ein zu wandelndes analoges Eingangssignal (Sig_{A}) eingangsseitig zugeführt werden kann, um ein trägerloses amplitudenmoduliertes Signal (Sig_{AM}) zu erhalten,
- einen Addierer (7), um zu dem trägerlosen amplitudenmodulierten Signal (Sig_{AM}) ein um 90° verschobenes, bevorzugt sinusförmiges Trägersignal (Sig_{T90}) zu addieren und ein phasenmoduliertes Signal (Sig_{PM}) zu erhalten,
- einen Begrenzer (11), dem das phasenmodulierte Signal (Sig_{PM}) zugeführt werden und mit dem eine Störamplitudenmodulation in dem phasenmodulierten Signal (Sig_{PM}) unterdrückt werden kann,
- eine Demodulationseinrichtung (16), der das von dem Begrenzer (11) ausgegebene Signal (Sig_{BA}) zugeführt und darin mit wenigstens einem Abtast-Clocksignal (CLKO-CLK3) abgetastet werden kann,
**dadurch gekennzeichnet, dass**
- die Vorrichtung (1) Mittel zur Phasenlagenänderung umfasst, die ausgebildet und/oder eingerichtet sind, um die Phasenlage des wenigstens einen Abtast-Clocksignals (CLK0-CLK3) zur Erzielung einer erhöhten Auflösung dynamisch zu ändern, insbesondere um Schritte von weniger als 40°, bevorzugt um Schritte von weniger als 20°, besonders bevorzugt um Schritte von weniger als 10°.

13. Vorrichtung (1) nach Anspruch 12,
**dadurch gekennzeichnet, dass**
die Vorrichtung (1), bevorzugt die Demodulationseinrichtung (16), eine Takterzeugungseinrichtung (17) zur Erzeugung des wenigstens einen Abtast-Clocksignals (CLK0-CLK3) aufweist, bevorzugt, wobei die Takterzeugungseinrichtung (17) wenigstens ein Takterzeugungsmodul (22, 23, 24) aufweist, das eine Phasenregelschleife (PLL) mit einem insbesondere spannungsgesteuerten Oszillator (VCO) umfasst, insbesondere, wobei der Oszillator (VCO) wenigstens einen phasenvariablen Abgriff (28) und bevorzugt mehrere phasenstarre Abgriffe (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei der phasenvariable Abgriff (28) mit dem Rückkoppelpfad (31) des Oszillators (VCO) verbunden ist, so dass ein von dem phasenvariable Abgriff (28) stammendes Signal dem Oszillator (VCO) als Rückkoppelsignal insbesondere eingangsseitig wieder zugeführt werden kann, und die Mittel zur Phasenlagenänderung ausgebildet und/oder eingerichtet sind, um die die Phasenlage des von dem phasenvariable Abgriff (28) stammenden Signals dynamisch um Schritte von 360°/n zu ändern.

14. Vorrichtung (1) nach Anspruch 12 oder 13, zur Durchführung des Verfahrens nach Anspruch 10,
**dadurch gekennzeichnet, dass**
die Demodulationseinrichtung (16) ausgebildet und/oder eingerichtet ist, um eine Flächenüberlappung zwischen dem von dem Begrenzer (11) ausgegebenen, der Demodulationseinrichtung (16) zugeführten Signal (Sig_{BA}) und einem Referenzsignal zu berechnen, insbesondere über mehrere Perioden.

15. Vorrichtung (1) nach einem der Ansprüche 12 bis 14, zur Durchführung des Verfahrens nach Anspruch 11,
**dadurch gekennzeichnet, dass**
die Demodulationseinrichtung (16) wenigstens ein XOR-Modul (20) und wenigstens einen dem XOR-Modul (20) nachgeschalteten Integrator (21) umfasst.

16. Vorrichtung (1) nach einem der Ansprüche 12 bis 15,
**dadurch gekennzeichnet, dass**
die Vorrichtung (1), bevorzugt die Demodulationseinrichtung (16), wenigstens einen Signal-Puffer (18), insbesondere Signal-FIFO-Puffer, umfasst, in dem Signal-Abtastwerte, die infolge der Abtastung des von dem Begrenzer (11) ausgegebenen Signals (Sig_{BA}) mit dem wenigstens einen Abtast-Clocksignal (CLK0-CLK3) vorliegen, zwischengespeichert werden können, und von dem mit einer im Vergleich zu der Frequenz des wenigstens einen Abtast-Clocksignals (CLK0-CLK3) niedrigeren Frequenz jeweils mehrere Signal-Abtastwerte ausgegeben werden können,
und die Vorrichtung, bevorzugt die Demodulationseinrichtung (16), wenigstens einen Referenz-Puffer (19), insbesondere Referenz-FIFO-Puffer, umfasst, in dem Referenz-Abtastwerte, die infolge einer Abtastung eines Referenzsignals (Sig_{RF}) mit dem wenigstens einen Abtast-Clocksignal (CLK0-CLK3) vorliegen, zwischengespeichert werden können, und von dem mit einer im Vergleich zu der Frequenz des wenigstens einen Abtast-Clocksignals (CLK0-CLK3) niedrigeren Frequenz jeweils mehrere Referenz-Abtastwerte ausgegeben werden können.

17. Vorrichtung (1) nach Anspruch 14 und 16,
**dadurch gekennzeichnet, dass**
der wenigstens eine Signal-Puffer (18) mit einem Eingang des XOR-Moduls (20) verbunden ist, und dass der wenigstens eine Referenz-Puffer (19) mit einem anderen Eingang des XOR-Moduls (20) verbunden ist.

18. Vorrichtung (1) nach einem der Ansprüche 12 bis 17,
**dadurch gekennzeichnet, dass**
zwischen dem Amplitudenmodulator (2) und der Demodulationseinrichtung (16) wenigstens eine galvanische Trennung vorgesehen ist, insbesondere, wobei die wenigstens eine galvanische Trennung wenigstens ein Paar von Koppelkondensatoren (K) umfasst.

## Claims

1. Method for converting an analogue input signal (Sig_{A}) into a digital output signal (Sig_{O}), comprising the steps
- feeding the analogue input signal (Sig_{A}) to be converted to the input side of an amplitude modulator (2) with carrier suppression, in order to obtain a carrierless amplitude-modulated signal (Sig_{AM}),
- using an adder (7) to add a preferably sinusoidal carrier signal offset by 90° (Sig_{T90}) to the amplitude-modulated signal (Sig_{AM}) output by the amplitude modulator (2), in order to obtain a phase-modulated signal (Sig_{PM}),
- feeding the phase-modulated signal (Sig_{PM}) to a limiter (11), which is used to suppress interference amplitude modulation in the phase-modulated signal (Sig_{PM}),
- feeding the signal (Sig_{BA}) output by the limiter (11) to a demodulator (16) and sampling it therein with at least one sampling clock signal (CLK0-CLK3),
**characterised in that**
- the phase position of the at least one sampling clock signal (CLK0-CLK3) is dynamically altered to achieve a higher resolution, particularly in steps of less than 40°, preferably in steps of less than 20°, particularly preferably in steps of less than 10°.

2. Method according to claim 1,
**characterised in that**
the phase position of the at least one sampling clock signal (CLK0-CLK3) is dynamically altered in equally large steps and/or in steps of 360°/n in each case, wherein n is a natural number greater than or equal to 30, particularly greater than or equal to 40, preferably greater than or equal to 50, particularly preferably greater than or equal to 100.

3. Method according to claim 1 or 2,
**characterised in that**
the phase position of the at least one sampling clock signal (CLK0-CLK3) is altered at multiple successive points in time, in particular separated from each other at equidistant intervals, wherein there is at least one microsecond between the separated points in time in each case.

4. Method according to one of the previous claims,
**characterised in that**
the phase position of the at least one sampling clock signal (CLK0-CLK3) is altered at least n/m times in steps of 360°/n, wherein m is a natural number greater than or equal to 1.

5. Method according to one of the previous claims,
**characterised in that**
the signal (Sig_{BA}) output by the limiter (11) is sampled in the demodulator (16) with multiple, in particular four, sampling clock signals (CLK0-CLK3) that preferably have a constant phase shift of 90° between them in each case, and the phase positions of all sampling clock signals (CLK0-CLK3) are dynamically altered to achieve a higher resolution, wherein the phase position alteration of the multiple sampling clock signals is preferably effected synchronously and/or in equally large steps, particularly of less than 40°.

6. Method according to claim 4 and 5,
**characterised in that**
m corresponds to the number of multiple sampling clock signals (CLK0-CLK3) that preferably have a constant phase shift between them, is preferably four.

7. Method according to one of the previous claims,
**characterised in that**
the at least one sampling clock signal (CLK0-CLK3) is generated from the output signal of a particularly voltage-controlled oscillator (VCO), which is an element in a phase-locked loop (PLL), and the dynamic alteration of the phase position of the at least one sampling clock signal (CLK0-CLK3) is achieved by dynamically altering the phase position of a feedback signal for the oscillator (VCO), which is tapped on the output side of the oscillator (VCO) and is fed to the oscillator (VCO) again, particularly on the input side, particularly in steps of less than 40°, preferably in steps of less than 20°, particularly preferably in steps of less than 10°.

8. Method according to claim 4 and 7,
**characterised in that**
the multiple sampling clock signals (CLK0-CLK3) are generated from the output signal of the one particularly voltage-controlled oscillator (VCO), and the dynamic alteration of the phase position of the feedback signal results in each case in an alteration of the phase positions of all sampling clock signals (CLK0-CLK3) synchronously and in equally large steps.

9. Method according to claim 7 or 8,
**characterised in that**
the oscillator (VCO) has at least one phase-variable tap (28) and preferably multiple phase-locked taps (27), wherein the at least one phase-variable tap (28) allows the 360° phase position of the oscillator (VCO) to be divided into n steps, wherein n is a natural number greater than or equal to 30, particularly greater than or equal to 40, preferably greater than or equal to 50, particularly preferably greater than or equal to 100, and wherein the phase-variable tap (28) is connected to the feedback path of the oscillator (VCO), so that a signal coming from the phase-variable tap (28) can be fed to the oscillator (VCO) again as a feedback signal, particularly on the input side, and the phase position of the signal coming from the phase-variable tap (28) is dynamically altered in steps of 360°/n.

10. Method according to one of the previous claims,
**characterised in that**
in the demodulator (16) an area overlap between the signal (Sig_{BA}) output by the limiter (11) and fed to the demodulator (16) and a reference signal is calculated, particularly over multiple cycles.

11. Method according to one of the previous claims,
**characterised in that** the signal (Sig_{BA}) output by the limiter (11) fed to the demodulator (16) is compared in the demodulator (16) in an XOR module (20) bit by bit to a reference signal (Sig_{RF}) after sampling with the at least one sampling clock signal (CLK0-CLK3), and the output signal of the XOR module (20) is integrated, preferably wherein, in each case, integration is maintained until the dynamic alteration of the phase position is effected over an angle range of 360°/m, wherein m is a natural number corresponding to the number of sampling clock signals (CLK0-CLK3).

12. Device (1) for converting an analogue input signal (Sig_{A}) into a digital output signal (Sig_{O}) for executing the method according to one of the previous claims, comprising
- an amplitude modulator (2) with carrier suppression, to which an analogue input signal (Sig_{A}) to be converted can be fed on the input side, in order to obtain a carrierless amplitude-modulated signal (Sig_{AM}),
- an adder (7), in order to add a preferably sinusoidal carrier signal offset by 90° (Sig_{T90}) to the carrierless amplitude-modulated signal (Sig_{AM}) and to obtain a phase-modulated signal (Sig_{AM}),
- a limiter (11), to which the phase-modulated signal (Sig_{PM}) is fed and with which interference amplitude modulation in the phase-modulated signal (Sig_{PM}) can be suppressed,
- a demodulator (16), to which the signal (Sig_{BA}) output by the limiter (11) is fed and can be sampled therein with at least one sampling clock signal (CLK0-CLK3), **characterised in that**
- the device (1) comprises means for phase position alteration, which are embodied and/or set up to dynamically alter the phase position of the at least one sampling clock signal (CLK0-CLK3) to achieve a higher resolution, particularly in steps of less than 40°, preferably in steps of less than 20°, particularly preferably in steps of less than 10°.

13. Device (1) according to claim 12,
**characterised in that**
the device (1), preferably the demodulator (16), has a clock generator (17) for generating the at least one sampling clock signal (CLK0-CLK3), preferably wherein the clock generator (17) has at least one clock generation module (22, 23, 24), which comprises a phase-locked loop (PLL) with a particularly voltage-controlled oscillator (VCO), wherein in particular the oscillator (VCO) has at least one phase-variable tap (28) and preferably multiple phase-locked taps (27), wherein the at least one phase-variable tap (28) allows the 360° phase position of the oscillator (VCO) to be divided into n steps, wherein n is a natural number greater than or equal to 30, particularly greater than or equal to 40, preferably greater than or equal to 50, particularly preferably greater than or equal to 100, and wherein the phase-variable tap (28) is connected to the feedback path (31) of the oscillator (VCO), so that a signal coming from the phase-variable tap (28) can be fed to the oscillator (VCO) again as a feedback signal, particularly on the input side, and the means of phase position alteration are embodied and/or set up to dynamically alter the phase position of the signal coming from the phase-variable tap (28) in steps of 360°/n.

14. Device (1) according to claim 12 or 13, for executing the method according to claim 10,
**characterised in that**
the demodulator (16) is embodied and/or set up to calculate an area overlap between the signal (Sig_{BA}) output by the limiter (11) fed to the demodulator (16) and a reference signal, particularly over multiple cycles.

15. Device (1) according to one of claims 12 to 14, for executing the method according to claim 11,
**characterised in that**
the demodulator (16) comprises at least one XOR module (20) and at least one integrator (21) downstream of the XOR module (20).

16. Device (1) according to one of claims 12 to 15, **characterised in that**
the device (1), preferably the demodulator (16), comprises at least one signal buffer (18), in particular a FIFO signal buffer, in which the signal sampling values, which are present because of the sampling of the signal (Sig_{BA}) output by the limiter (11) with the at least one sampling clock signal (CLK0-CLK3), can be buffered, and from which multiple signal sampling values can be output at a lower frequency in each case in comparison to the frequency of the at least one sampling clock signal (CLK0-CLK3),
and the device, preferably the demodulator (16), comprises at least one reference buffer (19), in particular a FIFO reference buffer, in which the reference sampling values, which are present because of a sampling of a reference signal (Sig_{RF}) with the at least one sampling clock signal (CLKO-CLK3), can be buffered, and from which multiple reference sampling values can be output at a lower frequency in each case in comparison to the frequency of the at least one sampling clock signal (CLK0-CLK3).

17. Device (1) according to claim 14 and 16,
**characterised in that**
the at least one signal buffer (18) is connected to an input of the XOR module (20) and that the at least one reference buffer (19) is connected to another input of the XOR module (20).

18. Device (1) according to one of claims 12 to 17,
**characterised in that**
at least one galvanic isolation is provided between the amplitude modulator (2) and the demodulator (16), in particular wherein the at least one galvanic isolation comprises at least one pair of coupling capacitors (K).

## Revendications

1. Procédé de transformation d'un signal (Sig_{A}) d'entrée analogique en un signal (Sig_{O}) de sortie numérique, comprenant les stades
- on envoie du côté de l'entrée le signal (Sig_{A}) d'entrée analogique à transformer à un modulateur (2) d'amplitude à suppression de porteuse, afin d'obtenir un signal (Sig_{AM}) modulé en amplitude sans porteuse,
- au signal (Sig_{AM}) modulé en amplitude donné par le modulateur (2) d'amplitude, on ajoute dans un additionneur (7) un signal (Sig_{T90}) de porteuse décalé de 90°, de préférence sinusoïdal, afin d'obtenir un signal (Sig_{PM}) modulé en phase,
- on envoie le signal (Sig_{PM}) modulé en phase à un limiteur (11), au moyen duquel on supprime une modulation d'amplitude parasite dans le signal (Sig_{PM}) modulé en phase,
- on envoie le signal (Sig_{BA}) donné par le limiteur (11) à un dispositif (16) de démodulation et on l'y échantillonne au moyen d'un signal (CLK0-CLK3) d'horloge d'échantillonnage,
**caractérisé en ce qu'**
- on modifie dynamiquement la position en phase du au moins un signal (CLK0-CLK3) d'horloge d'échantillonnage pour l'obtention d'une résolution augmentée, en particulier de pas de moins de 40°, de préférence de pas de moins de 20°, d'une manière particulièrement préférée de pas de moins de 10°.

2. Procédé suivant la revendication 1,
**caractérisé en ce que**
l'on modifie dynamiquement, de pas respectivement de même dimension, la position en phase du au moins un signal (CLK0-CLK3) d'horloge d'échantillonnage et/ou on la modifie dynamiquement, de pas de 360°/n, dans lequel n est un nombre naturel supérieur ou égal à 30, en particulier supérieur ou égal à 40, de préférence supérieur ou égal à 50, d'une manière particulièrement préférée supérieur ou égal à 100.

3. Procédé suivant la revendication 1 ou 2,
**caractérisé en ce que**
l'on modifie la position en phase du au moins un signal (CLKO-CLK3) d'horloge d'échantillonnage en plusieurs instants à distance se succédant, en particulier équidistants les uns des autres, dans lequel, de préférence entre les instants à distance s'écoule au moins respectivement au moins une microseconde.

4. Procédé suivant l'une des revendications précédentes,
**caractérisé en ce que**
l'on modifie, de pas de 360°/n, la position en phase du au moins un signal (CLK0-CLK3) d'horloge d'échantillonnage au moins n/m fois, dans lequel m est un nombre entier supérieur ou égal à 1.

5. Procédé suivant l'une des revendications précédentes,
**caractérisé en ce que**
l'on échantillonne le signal (Sig_{BA}) donné par le limiteur (11) dans le dispositif (16) de démodulation par plusieurs, de préférence par quatre, signaux (CLK0-CLK3) d'horloge d'échantillonnage déphasés, de préférence de manière fixe, les uns des autres respectivement de 90°, et on modifie dynamiquement les positions en phase de tous les signaux (CLK0-CLK3) d'horloge d'échantillonnage pour obtenir une augmentation de la résolution, dans lequel la modification de la position en phase de plusieurs signaux d'horloge d'échantillonnage s'effectue de préférence respectivement de manière synchrone et/ou à des pas de même dimension, en particulier de moins de 40°.

6. Procédé suivant la revendication 4 et 5,
**caractérisé en ce que**
m correspond au nombre des plusieurs signaux (CLK0-CLK3) d'horloge d'échantillonnage déphasés les uns par rapport aux autres, de préférence de manière fixe, ce nombre étant de préférence de quatre.

7. Procédé suivant l'une des revendications précédentes,
**caractérisé en ce que**
l'on produit le au moins un signal (CLK0-CLK3) d'horloge d'échantillonnage à partir du signal de sortie d'un oscillateur (VCO), en particulier commandé en tension, qui est des parties constituantes d'une boucle (PLL) à verrouillage de phase, et on obtient la modification dynamique de la position en phase du au moins un signal (CLK0-CLK3) d'horloge d'échantillonnage, en modifiant dynamiquement, en particulier de pas de moins de 40°, de préférence de pas de moins de 20°, d'une manière particulièrement préférée de pas de moins de 10°, la position en phase d'un signal de réaction pour l'oscillateur (VCO), qui est prélevé du côté de la sortie de l'oscillateur (VCO) et qui est retourné, en particulier du côté de l'entrée à l'oscillateur (VCO) .

8. Procédé suivant la revendication 4 et 7,
**caractérisé en ce que**
l'on produit des plusieurs signaux (CLK0-CLK3) d'horloge d'échantillonnage à partir du signal de sortie du un oscillateur (VCO), en particulier commandé en tension, et la modification dynamique de la position en phase du signal de réaction se traduit, de manière synchrone et avec des pas de même dimension, respectivement par une modification des positions en phase de tous les signaux (CLK0-CLK3) d'horloge d'échantillonnage.

9. Procédé suivant la revendication 7 ou 8,
**caractérisé en ce que**
l'oscillateur (VCO) a au moins une prise (28) variable en phase et de préférence plusieurs prises (27) fixes en phase, dans lequel la au moins une prise (28) variable en phase permet de subdiviser la position en phase de 360° de l'oscillateur (VCO) en n pas, dans lequel n est un nombre naturel supérieur ou égal à 30, en particulier supérieur ou égal à 40, d'une manière préférée supérieur ou égal à 50, d'une manière particulièrement préférée supérieur ou égal à 100, et dans lequel la prise (28) variable en phase est reliée au chemin de réaction de l'oscillateur (VCO), de manière à pouvoir retourner, en particulier du côté de l'entrée, comme signal de réaction à l'oscillateur (VCO), un signal provenant de la prise (28) variable en phase et on modifie dynamiquement de pas de 360°/n la position en phase du signal provenant de la prise (28) variable en phase.

10. Procédé suivant l'une des revendications précédentes,
**caractérisé en ce que**
l'on calcule dans le dispositif (16) de démodulation un chevauchement de surfaces entre un signal de référence et le signal (Sig_{BA}) donné par le limiteur (11) et envoyé au dispositif (16) de démodulation, en particulier sur plusieurs durées.

11. Procédé suivant l'une des revendications précédentes,
**caractérisé en ce que**
l'on compare un signal (Sig_{RF}) de référence bit par bit dans un module (20) XOU dans le dispositif (16) de démodulation au signal (Sig_{BA}) donné par le limiteur (11) et envoyé au dispositif (16) de démodulation, après l'échantillonnage par le au moins un signal (CLK0-CLK3) d'échantillonnage et on intègre le signal de sortie du module (20) XOU, dans lequel, de préférence on intègre respectivement jusqu'à ce que la modification dynamique de la position en phase s'est effectuée sur une partie angulaire de 360°/m, m étant un nombre entier, qui correspond au nombre des signaux (CLK0-CLK3) d'horloge de balayage.

12. Montage (1) de transformation d'un signal (Sig_{A}) d'entrée analogique en un signal (Sig_{O}) de sortie numérique pour effectuer le procédé suivant l'une des revendications précédentes, comprenant
- un modulateur (2) d'amplitude à suppression de porteuse, auquel peut être envoyé, du côté de l'entrée, un signal (Sig_{A}) d'entrée analogique à transformer, afin d'obtenir un signal (Sig_{AM}) démodulé en amplitude sans porteuse,
- un additionneur (7), pour ajouter au signal (Sig_{AM}) modulé en amplitude sans porteuse, un signal (Sig_{T90}) de porteuse décalé de 90°, de préférence sinusoïdal, et d'obtenir un signal (Sig_{PM}) modulé en phase,
- un limiteur (11), auquel on peut envoyer le signal (Sig_{PM}) modulé en phase, et par lequel une modulation en amplitude parasite dans le signal (Sig_{PM}) modulé en phase peut être supprimée,
- un dispositif (16) de démodulation, qui envoie le signal (Sig_{BA}) donné par le limiteur (11) , et peut l'y échantillonner par au moins un signal (CLK0-CLK3) d'horloge d'échantillonnage,
**caractérisé en ce que**
- le montage (1) comprend des moyens de modification de la position en phase, qui sont constitués et/ou agencés pour modifier dynamiquement la position en phase du au moins un signal (CLK0-CLK3) d'horloge d'échantillonnage pour l'obtention d'une résolution augmentée, en particulier de pas de moins de 40°, de préférence de pas de moins de 20°, d'une manière particulièrement préférée de pas de moins de 10°.

13. Montage (1) suivant la revendication 12,
**caractérisé en ce que**
le montage (1), de préférence le dispositif (16) de démodulation, a un dispositif (17) de production de rythme pour la production du au moins un signal (CLK0-CLK3) d'horloge d'échantillonnage, dans lequel, de préférence le dispositif (17) de production de rythme a au moins un module (22, 23, 24) de production de rythme, qui comprend une boucle (PLL) à verrouillage de phase ayant un oscillateur (VCO), en particulier commandé en tension, dans lequel en particulier l'oscillateur (VCO) a au moins une prise (28) variable en phase, et de préférence plusieurs prises (27) fixes en phase, dans lequel la au moins une prise (28) variable en phase permet de subdiviser la position en phase de 360° de l'oscillateur (VCO) en des pas, dans lequel n est un nombre entier supérieur ou égal à 30, en particulier supérieur ou égal à 40, de préférence supérieur ou égal à 50, d'une manière particulièrement préférée supérieur ou égal à 100, et dans lequel la prise (28) variable en phase est reliée au chemin (31) de réaction de l'oscillateur (VCO), de manière à pouvoir retourner, en particulier du côté de l'entrée, comme signal de réaction à l'oscillateur (VCO), un signal provenant de la prise (28) variable en phase, et les moyens de modification de phase sont constitués et/ou agencés pour modifier dynamiquement, en pas de 360°/n, la position en phase du signal provenant de la prise (28) variable en phase.

14. Montage (1) suivant la revendication 12 ou 13, pour effectuer le procédé suivant la revendication 10,
**caractérisé en ce que**
le dispositif (16) de démodulation est constitué et agencé pour calculer un chevauchement de surfaces entre un signal de référence et le signal (Sig_{BA}) donné par le limiteur (11) et envoyé au dispositif (16) de démodulation, en particulier sur plusieurs durées.

15. Montage (1) suivant l'une des revendications 12 à 14, pour effectuer le procédé suivant la revendication 11,
**caractérisé en ce que**
le dispositif (16) de démodulation comprend au moins un module (20) XOU et au moins un intégrateur (21) monté en aval du module (20) XOU.

16. Montage (1) suivant l'une des revendications 12 à 15, **caractérisé en ce que**
le montage (1), de préférence le dispositif (16) de démodulation, comprend au moins un tampon (18) de signal, en particulier un tampon FIFO de signal, dans lequel des valeurs d'échantillonnage du signal, qui sont présentes en raison de l'échantillonnage du signal (Sig_{BA}), donné par le limiteur (11), par le au moins un signal (CLK0-CLK3) d'horloge d'échantillonnage, peuvent être mises en mémoire tampon, et par lequel, par une comparaison à la fréquence du au moins un signal (CLK0-CLK3) d'horloge d'échantillonnage de fréquence plus basse, respectivement plusieurs valeurs d'échantillonnage de signal peuvent être données,
et le montage, de préférence le dispositif (16) de démodulation, comprend au moins un tampon (19) de référence, en particulier un tampon FIFO de référence, dans lequel des valeurs d'échantillonnage de référence, qui sont présentes en raison d'un échantillonnage d'un signal (Sig_{RF}) de référence par le au moins un signal (CLK0-CLK3) d'horloge d'échantillonnage, peuvent être mises en mémoire tampon, et par lequel, par une fréquence plus basse par rapport à la fréquence du au moins un signal (CLK0-CLK3) d'horloge d'échantillonnage, respectivement plusieurs valeurs d'échantillonnage de référence peuvent être données.

17. Montage (1) suivant la revendication 14 et 16,
**caractérisé en ce que**
le au moins un tampon (18) de signal est connecté à l'entrée du module (20) XOU, et **en ce que** le au moins un tampon (19) de référence est connecté à une autre entrée du module (20) XOU.

18. Montage (1) suivant l'une des revendications 12 à 17,
**caractérisé en ce qu'**
entre le modulateur (2) d'amplitude et le dispositif (16) de démodulation, est prévue au moins une séparation galvanique, dans lequel, en particulier la au moins une séparation galvanique comprend au moins une paire de condensateurs (K) de couplage.
